(19) Europäisches Patentamt
European Patent Office
Office européen des brevets

(11) **EP 4 020 085 A1**

(12) **EUROPEAN PATENT APPLICATION**

(43) Date of publication:
**29.06.2022 Bulletin 2022/26**

(21) Application number: **20216767.2**

(22) Date of filing: **22.12.2020**

(51) International Patent Classification (IPC):
**G03F 7/20** (2006.01)  **G06N 3/08** (2006.01)

(52) Cooperative Patent Classification (CPC):
**G03F 7/70625; G03F 7/705; G06N 3/02; G06N 3/08; G06N 20/00**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **PISARENCO, Maxim**
  **5500 AH Veldhoven (NL)**
• **BATISTAKIS, Chrysostomos**
  **5500 AH Veldhoven (NL)**
• **MIDDLEBROOKS, Scott Anderson**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **MACHINE LEARNING BASED IMAGE GENERATION OF AFTER-DEVELOPMENT OR AFTER-ETCH IMAGES**

(57) A method for training a machine learning model includes obtaining a set of unpaired after-development images (AD) and after-etch (AE) images associated with a substrate. Each AD image in the set is obtained at a location on the substrate that is different from the location at which any of the AE images is obtained. The method further includes training the machine learning model to generate a predicted AE image based on the AD images and the AE images, wherein the predicted AE image corresponds to a location from which an input AD image of the AD images is obtained, and corresponding non-transitory computer-readable medium.

**FIG. 6A**

**Description**

TECHNICAL FIELD

The embodiments provided herein relate to semiconductor manufacturing, and more particularly to inspecting a semiconductor substrate.

BACKGROUND

A lithographic apparatus is a machine that applies a desired pattern onto a substrate, usually onto a target portion of the substrate. A lithographic apparatus can be used, for example, in the manufacture of integrated circuits (ICs) or other devices. In that instance, a patterning device, which is alternatively referred to as a mask or a reticle, may be used to generate a pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti parallel to this direction. It is also possible to transfer the pattern from the patterning device to the substrate by imprinting the pattern onto the substrate.

In order to monitor one or more steps of a patterning process (i.e., a process of device manufacturing involving lithography, including, e.g., resist-processing, etching, development, baking, etc.), the patterned substrate is inspected and one or more parameters of the patterned substrate are determined. The one or more parameters may include, for example, edge placement errors (EPEs), which are distances between edges of patterns formed on the substrate and corresponding edges of the intended design of the patterns. This measurement may be performed on patterns of the product substrate itself and/or on a dedicated metrology target provided on the substrate. There are various techniques for making measurements of the microscopic structures formed in a patterning process, including the use of a scanning electron microscope (SEM) and/or various specialized tools.

SUMMARY

In some embodiments, there is provided a non-transitory computer-readable medium having instructions that, when executed by a computer, cause the computer to execute a method for training a machine learning model. The method includes: obtaining a set of unpaired after-development (AD) images and after-etch (AE) images associated with a substrate, wherein each AD image is obtained from a location on the substrate that is different from all locations at which the AE images are obtained; and training the machine learning model to generate a predicted AE image based on the AD images and the AE images, wherein the predicted AE image corresponds to a location from which an input AD image of the AD images is obtained.

In some embodiments, there is provided a non-transitory computer-readable medium having instructions that, when executed by a computer, cause the computer to execute a method for training a machine learning model. The method includes: obtaining a set of unpaired AD images and AE images associated with a substrate, wherein each AD image is obtained from a location on the substrate that is different from all locations at which the AE images are obtained; and training the machine learning model to generate a predicted AE image, wherein the training includes: training an AE generator model of the machine learning model to generate the predicted AE image from an input AD image of the AD images such that a first cost function determined based on the input AD image and the predicted AE image is reduced, and training an AD generator model of the machine learning model to generate a predicted AD image from a reference AE image of the AE images such that a second cost function determined based on the reference AE image and the predicted AD image is reduced.

In some embodiments, there is provided a non-transitory computer-readable medium having instructions that, when executed by a computer, cause the computer to execute a method for training a machine learning model. The method includes: obtaining a set of unpaired AD images and AE images associated with a substrate, wherein each AD image is obtained from a location on the substrate that is different from all locations at which the AE images are obtained; and training the machine learning model to generate a predicted AD image based on the AD images and the AE images, wherein the predicted AD image corresponds to a location from which an input AE image of the AE images is obtained.

In some embodiments, there is provided a non-transitory computer-readable medium having instructions that, when executed by a computer, cause the computer to execute a method for training a machine learning model. The method includes: obtaining a set of unpaired AD images and AE images associated with a substrate, wherein each AD image is obtained from a location on the substrate that is different from all locations at which the AE images are obtained; and training the machine learning model to generate a predicted AE image and a predicted AD image based on the AD images and the AE images, wherein the predicted AE image corresponds to a location from which an input AD image of the AD images is obtained, and wherein the predicted AD image corresponds to a location from which an input AE image of the AE images is obtained.

In some embodiments, there is provided a method for training a machine learning model. The method includes: obtaining a set of unpaired AD images and AE images associated with a substrate, wherein each AD image is obtained from a location on the substrate that is different from all locations at which the AE images are obtained; and training the machine learning model to generate a predicted AE image based on the AD images and the AE images, wherein the predicted AE image corresponds to a location from which an input AD image of the AD images is obtained.

In some embodiments, there is provided a method for training a machine learning model. The method includes: obtaining a set of unpaired AD images and AE images associated with a substrate, wherein each AD image is obtained from a location on the substrate that is different from all locations at which the AE images are obtained; and training the machine learning model to generate a predicted AD image based on the AD images and the AE images, wherein the predicted AD image corresponds to a location from which an input AE image of the AE images is obtained.

In some embodiments, there is provided a method for training a machine learning model. The method includes: obtaining a set of unpaired AD images and AE images associated with a substrate, wherein each AD image is obtained from a location on the substrate that is different from all locations at which the AE images are obtained; and training the machine learning model to generate a predicted AE image and a predicted AD image based on the AD images and the AE images, wherein the predicted AE image corresponds to a location from which an input AD image of the AD images is obtained, and wherein the predicted AD image corresponds to a location from which an input AE image of the AE images is obtained.

In some embodiments, there is provided an apparatus for training a machine learning model. The apparatus includes a memory storing a set of instructions; and at least one processor configured to execute the set of instructions to cause the apparatus to perform a method, which includes: obtaining a set of unpaired AD images and AE images associated with a substrate, wherein each AD image is obtained from a location on the substrate that is different from all locations at which the AE images are obtained; and training the machine learning model to generate a predicted AE image based on the AD images and the AE images, wherein the predicted AE image corresponds to a location from which an input AD image of the AD images is obtained.

In some embodiments, there is provided an apparatus for training a machine learning model. The apparatus includes a memory storing a set of instructions; and at least one processor configured to execute the set of instructions to cause the apparatus to perform a method, which includes: obtaining a set of unpaired AD images and AE images associated with a substrate, wherein each AD image is obtained from a location on the substrate that is different from all locations at which the AE images are obtained; and training the machine learning model to generate a predicted AD image based on the AD images and the AE images, wherein the predicted AD image corresponds to a location from which an input AE image of the AE images is obtained.

In some embodiments, there is provided an apparatus for training a machine learning model. The apparatus includes a memory storing a set of instructions; and at least one processor configured to execute the set of instructions to cause the apparatus to perform a method, which includes: obtaining a set of unpaired AD images and AE images associated with a substrate, wherein each AD image is obtained from a location on the substrate that is different from all locations at which the AE images are obtained; and training the machine learning model to generate a predicted AE image and a predicted AD image based on the AD images and the AE images, wherein the predicted AE image corresponds to a location from which an input AD image of the AD images is obtained, and wherein the predicted AD image corresponds to a location from which an input AE image of the AE images is obtained.

In some embodiments, there is provided an apparatus for generating a first image from a second image using a machine learning model. The apparatus includes a memory storing a set of instructions; and at least one processor configured to execute the set of instructions to cause the apparatus to perform a method, which includes: obtaining a given AD image associated with a given substrate, wherein the given AD image corresponds to a given location on the given substrate; and generating, via a machine learning model, a given predicted AE image using the given AD image, wherein the given predicted AE image corresponds to the given location, wherein the machine learning model is trained to generate a predicted AE image using a set of unpaired AD images and AE images associated with a substrate.

In some embodiments, there is provided an apparatus for generating a first image from a second image using a machine learning model. The apparatus includes a memory storing a set of instructions; and at least one processor configured to execute the set of instructions to cause the apparatus to perform a method, which includes: obtaining a given AE image associated with a given substrate, wherein the given AE image corresponds to a given location on the given substrate; and generating, via a machine learning model, a given predicted AD image using the given AE image, wherein the given predicted AD image corresponds to the given location, wherein the machine learning model is trained to generate a predicted AD image using a set of unpaired AD images and AE images associated with a substrate

## BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosed embodiments. In the drawings,

FIG. 1 schematically depicts a lithographic apparatus LA, in accordance with one or more embodiments.

FIG. 2 schematically depicts an embodiment of a lithographic cell or cluster, in accordance with one or more embodiments.

FIG. 3 illustrates a flow chart for simulating lithography in a lithographic projection apparatus, in accordance with one or more embodiments.

FIG. 4A is a block of diagram of an image generator model for generating a predicted after-etch (AE) image, in accordance with one or more embodiments.

FIG. 4B is a block of diagram of an image generator model for generating a predicted after-development (AD) image, in accordance with one or more embodiments.

FIG. 5 illustrates a training dataset, in accordance with one or more embodiments.

FIG. 6A is a block diagram of training an image generator model to predict an AE image, in accordance with one or more embodiments.

FIG. 6B is a block diagram of training an image generator model to predict an AD image, in accordance with one or more embodiments.

FIG. 7 schematically depicts preparation of a training dataset for training an image generator model, in accordance with one or more embodiments.

FIG. 8 is a flow diagram of a process for training an image generator model configured to generate a predicted AE image (and/or a predicted AD image), in accordance with one or more embodiments.

Figure 9A is a flow diagram of another process for training the image generator model to generate a predicted AE image or a predicted AD image, in accordance with one or more embodiments.

FIG. 9B is a flow diagram of a method for minimizing a first cost function associated with generating a predicted AE image, in accordance with one or more embodiments.

FIG. 9C is a flow diagram of a method for minimizing a second cost function associated with generating a predicted AD image, in accordance with one or more embodiments.

FIG. 10 is a flow diagram of a process for generating a predicted AE image using an image generator model, in accordance with one or more embodiments.

FIG. 11 is a block diagram of an example computer system CS which can assist in implementing the methods, flows, modules, components, or the apparatus disclosed herein, in accordance with one or more embodiments.

FIG. 12 schematically depicts an embodiment of an electron beam inspection apparatus, in accordance with one or more embodiments.

FIG. 13 schematically illustrates a further embodiment of an inspection apparatus, in accordance with one or more embodiments.

## DETAILED DESCRIPTION

In order to monitor one or more steps of a patterning process (i.e., a process of device manufacturing involving lithography, including, e.g., resist-processing, etching, development, baking, etc. for transferring a design layout (e.g., target pattern) onto a substrate), a patterned substrate is inspected and one or more parameters of the patterned substrate are determined. The one or more parameters may include, for example, edge placement errors (EPEs), which are distances between edges of patterns formed on the substrate and corresponding edges of the intended design of the patterns. Based on these parameters, one or more aspects of the design layout, the patterning process, or the lithographic apparatus may be adjusted to minimize a defect and therefore, improve the overall yield of the patterning process.

Some inspection methods for determining parameters of a patterned substrate include obtaining images of a pattern formed on a substrate (e.g., using a scanning electron microscope (SEM)) at various stages of the patterning process (e.g., after development and after etching processes) and analyzing them to determine the parameters. Some methods include obtaining an after-development (AD) image (which is an image obtained using the SEM after a development process of the substrate) and an after-etch (AE) image (which is an image obtained after an etching process of the substrate) at the same location on a substrate. A drawback with such a method is that obtaining images at the same location is time consuming and computing resource intensive (e.g., due to alignment issues) and imaging a location after the development process may affect the substrate (e.g., damage a resist) and this may affect the measurements (e.g., imaging the location) performed after the etch process. In order to overcome such drawbacks, some methods use a machine learning (ML) model to generate a predicted or simulated AE image for a given AD image. However, such ML methods may also have the same drawbacks as the previous methods. For example, to generate a corresponding AE image for a given AD image, or vice versa, the ML model may have to be trained with a number of paired AD and AE images in which each pair of AD and AE images is obtained from the same location. Generating such training data may not only be time consuming and computing resource intensive but may also impact what is measured after the etch process. These and other drawbacks exist.

Embodiments of the present disclosure facilitate training of a ML model to generate a predicted AE image for a given AD image using unpaired AD and AE images as training data. The unpaired AD and AE images is a dataset in which the AE images and AD images are obtained from different locations (e.g., no two images in the dataset are obtained from the same location on a substrate, or every AE image is obtained from a location different than all the locations from which the AD images are obtained). By using unpaired AD and AE images to generate a training dataset for training the ML model, the time consumed in generating the training dataset is minimized, and the impact on the after-etch images due to the effects of imaging of the locations for after-development images is minimized, thereby improving an accuracy in measuring the parameters associated the pattern on the substrate.

Before describing embodiments in detail, it is instructive to present an example environment in which embodiments may be implemented.

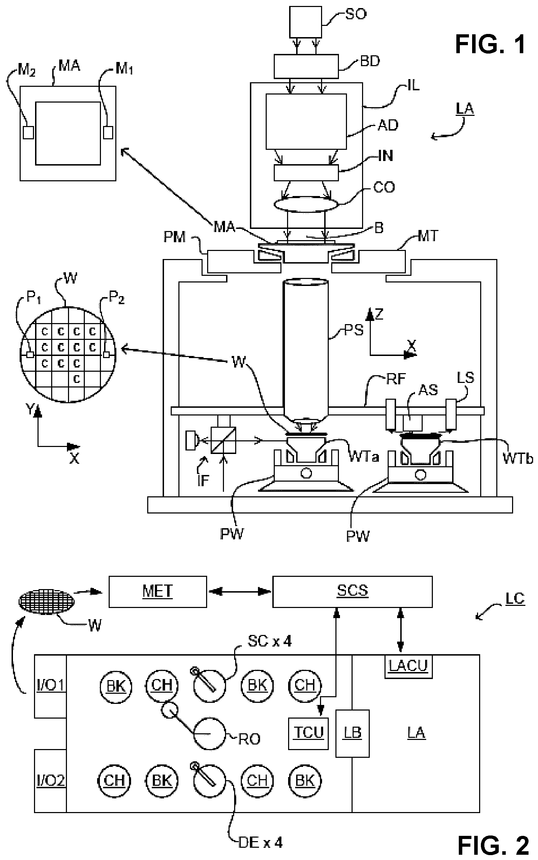

FIG. 1 schematically depicts a lithographic apparatus LA, in accordance with one or more embodiments. The apparatus comprises:

- an illumination system (illuminator) IL configured to condition a radiation beam B (e.g. UV radiation, DUV radiation or EUV radiation);
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WT constructed to hold a substrate (e.g. a resist-coated wafer) W and connected to a second positioner PW configured to accurately position the substrate in accordance with certain parameters; and
- a projection system (e.g. a refractive projection lens system) PL configured to project a pattern imparted to the radiation beam B by patterning device MA onto a target portion C (e.g. comprising one or more dies) of the substrate W, the projection system supported on a reference frame (RF).

The illumination system may include various types of optical components, such as refractive, reflective, magnetic, electromagnetic, electrostatic or other types of optical components, or any combination thereof, for directing, shaping, or controlling radiation.

The support structure supports the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so-called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may be of a type having two (dual stage) or more tables (e.g., two or more substrate tables WTa, WTb, two or more patterning device tables, a substrate table WTa and a table WTb below the projection system without a substrate that is dedicated to, for example, facilitating measurement, and/or cleaning, etc.). In such "multiple stage" machines the additional tables may be used in parallel, or preparatory steps may be carried out on one or more tables while one or more other tables are being used for exposure. For example, alignment measurements using an alignment sensor AS and/or level (height, tilt, etc.) measurements using a level sensor LS may be made.

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the patterning device and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Fig. 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases, the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD configured to adjust the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask) MA, which is held on the support structure (e.g., mask table) MT, and is patterned by the patterning device. Having traversed the patterning device MA, the radiation beam B passes through the projection system PL, which focuses the beam onto a target portion C of the substrate W. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Fig. 1) can be used to accurately position the patterning device MA with respect to the path of the radiation beam B, e.g., after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The depicted apparatus could be used in at least one of the following modes:

1. In step mode, the support structure MT and the substrate table WT are kept essentially stationary, while an entire pattern imparted to the radiation beam is projected onto a target portion C at one time (i.e., a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the support structure MT and the substrate table WT are scanned synchronously while a pattern imparted to the radiation beam is projected onto a target portion C (i.e., a single dynamic exposure). The velocity and direction of the substrate table WT relative to the support structure MT may be determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.

3. In another mode, the support structure MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above-described modes of use or entirely different modes of use may also be employed.

As shown in FIG. 2, the lithographic apparatus LA may form part of a lithographic cell LC, also sometimes referred to a lithocell or cluster, which also includes apparatuses to perform pre- and post-exposure processes on a substrate. Conventionally these include one or more spin coaters SC to deposit one or more resist layers, one or more developers DE to develop exposed resist, one or more chill plates CH and/or one or more bake plates BK. A substrate handler, or robot, RO picks up one or more substrates from input/output port I/O1, I/O2, moves them between the different process apparatuses and delivers them to the loading bay LB of the lithographic apparatus. These apparatuses, which are often collectively referred to as the track, are under the control of a track control unit TCU which is itself controlled by the supervisory control system SCS, which also controls the lithographic apparatus via lithography control unit LACU. Thus, the different apparatuses can be operated to maximize throughput and processing efficiency.

In order that a substrate that is patterned by the lithographic apparatus is done so correctly and consistently, it is desirable to inspect a patterned substrate to measure one or more properties such as EPEs, line thickness, critical dimension (CD), etc. Accordingly, a manufacturing facility in which the lithocell LC is located also typically includes a metrology system MET which receives some or all of the substrates W that have been processed in the lithocell. The metrology system MET may be part of the lithocell LC, for example it may be part of the lithographic apparatus LA.

Metrology results may be provided directly or indirectly to the supervisory control system SCS. If an error is detected, an adjustment may be made to patterning of a subsequent substrate (especially if the inspection can be done soon and fast enough that one or more other substrates of the batch are still to be patterned) and/or to subsequent patterning of the patterned substrate. Also, an already patterned substrate may be stripped and reworked to improve yield, or discarded, thereby avoiding performing further processing on a substrate known to be faulty. In a case where only some target portions of a substrate are faulty, further patterning may be performed only on those target portions which are good.

Within a metrology system MET, an inspection apparatus is used to determine one or more properties of the substrate, and in particular, how one or more properties of different substrates vary, or different layers of the same substrate vary from layer to layer. The inspection apparatus may be integrated into the lithographic apparatus LA or the lithocell LC or may be a stand-alone device. To enable rapid measurement, it is desirable that the inspection apparatus measures one or more properties in the patterned resist layer immediately after the patterning. However, for example, a latent image in the resist has a low contrast - there is only a very small difference in refractive index between the parts of the resist which have been exposed to radiation and those which have not - and not all inspection apparatuses have sufficient sensitivity to make useful measurements of the latent image. Therefore, measurements may be taken after the post-exposure bake step (PEB) which is customarily the first step carried out on an exposed substrate and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of a faulty substrate but may still provide useful information.

The inspection of a substrate patterned in a patterning process may involve capturing images (e.g., SEM images) of the substrate. Some parameters of the patterned substrate may be extracted from the images alone, but other parameters may require comparison with other data, such as the design layout of the patterns formed on the substrate.

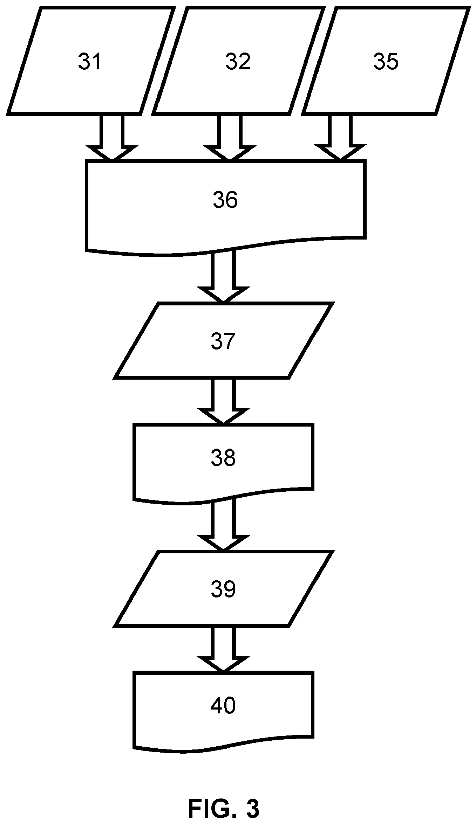

FIG. 3 illustrates an exemplary flow chart for simulating lithography in a lithographic projection apparatus, according to an embodiment. A source model 31 represents one or more optical characteristics (including radiation intensity distribution and/or phase distribution) of illumination. A projection optics model 32 represents one or more optical characteristics (including changes to the radiation intensity distribution and/or the phase distribution caused by the projection optics) of the projection optics. A patterning device model 35 represents one or more optical characteristics of the patterning device (including changes to the radiation intensity distribution and/or the phase distribution caused by a given design layout represented on the patterning device). An aerial image 36 can be simulated from the source model 31, the projection optics model 32 and the patterning device model 35. A resist image 38 can be simulated from the aerial image 36 using a resist model 37. The resist model 37 represents physical and chemical properties of the resist (e.g., behavior of the resist in exposure, post exposure bake and development). An etch image 40 can be simulated from the resist image 38 using an etching model 39. The etching model 39 represents characteristics of the etching process of the substrate.

More specifically, the source model 31 can represent one or more optical characteristics of the illumination including, but not limited to, a numerical aperture setting, an illumination sigma (σ) setting and/or a particular illumination shape (e.g., off-axis illumination such as annular, quadrupole, dipole, etc.). The projection optics model 32 can represent one or more optical characteristics of the projection optics, including aberration, distortion, one or more refractive indices, one or more physical sizes, one or more physical dimensions, etc. The patterning device model 35 can represent one or more physical properties of a physical patterning device, as described, for example, in U.S. Patent No. 7,587,704, which is incorporated by reference in its entirety. The etching model 39 can represent one or more characteristics of the etching process such as gas composition, (microwave) power, duration, one or more materials of the substrate, etc.

The source model 31, the projection optics model 32, the patterning device model 35, and the etching model 39 may model contributions of the patterning process to deviations of the aerial, resist or etched image from the design layout. The patterning device model 35 may model the contribution of the RETs and inaccuracy of the patterning device to deviations of the aerial, resist or etched image from the design layout. The various models may be calibrated at least partially from experimental data.

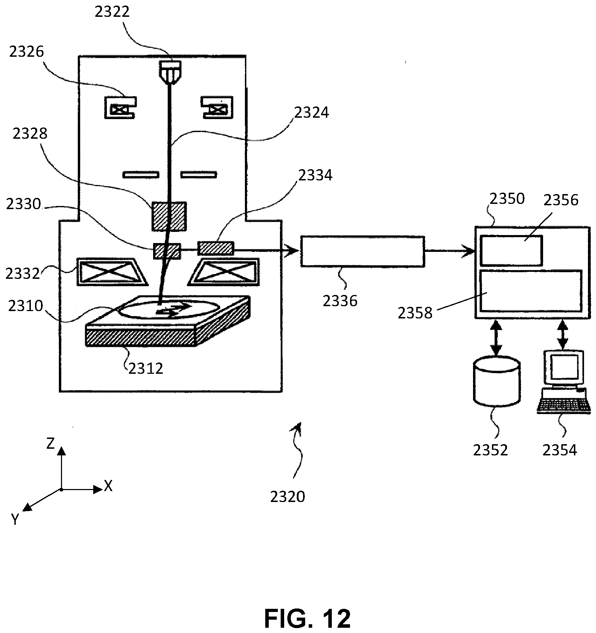

The present disclosure describes embodiments for training an image generator model to generate an after-etch (AE) image from an after-development (AD) image of a substrate, or vice versa, using unpaired AD and AE images of one or more substrates as training data. In some embodiments, a lithographic process creates printed patterns (e.g., circuit patterns for integrated circuits or computer chips) on a substrate based on, for example, a target pattern. The patterned substrate may be inspected at various stages of the process by capturing images (e.g., using an image capture device such as a SEM illustrated in FIGS. 12-13) of the substrate. In some embodiments, AD and AE images are examples of such images where the AD image corresponds to an image of the substrate captured after the development stage in the lithographic process and the AE image corresponds to an image of the substrate captured after the etching stage in the lithographic process. The AD or AE images predicted by the image generator model may be analyzed to obtain various measurements or parameters such as edge placement error (EPE), local EPE (local EPE), stochastic EPE (SEPE), CD, CD uniformity (CDU), local CDU (LCDU), line thickness, or other metrology data. After the inspection of the substrate, one or more design variables may be adjusted based on the determined parameters to minimize a defect in forming a pattern on the substrate. The term "design variables" as used herein comprises a set of parameters of a lithographic projection apparatus or a patterning process, for example, parameters a user of the lithographic projection apparatus can adjust, or image characteristics a user can adjust by adjusting those parameters. It should be appreciated that any characteristics of a lithographic projection process, including those of the source, the patterning device, the projection optics, and/or resist characteristics can be among the design variables in the optimization.

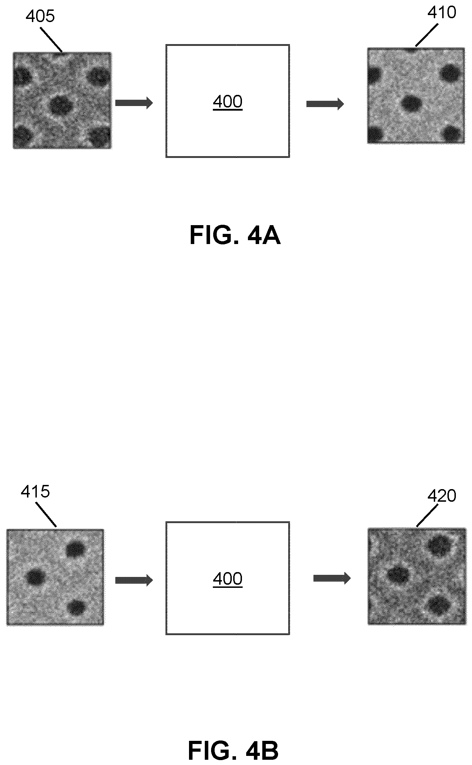

FIG. 4A is a block of diagram of an image generator model 400 for generating a predicted AE image, in accordance with one or more embodiments. The image generator model 400 may be configured to generate a predicted AE image 410 from an AD image 405. In some embodiments, the predicted AE image 410 may be an AE image that corresponds to or is paired with the AD image 405 (e.g., the predicted AE image 410 is a prediction of how the after-etch image may look like when the substrate is imaged using the image capture device at a location from which the AD image 405 is obtained). In some embodiments, the image generator model 400 may include one or more ML models that are trained to generate a predicted AE image using an AD image.

While the image generator model 400 may generate a predicted AE image from an AD image, the image generator model 400 may also be configured to generate a predicted AD image from an AE image. FIG. 4B is a block of diagram of an image generator model 400 for generating a predicted AD image, in accordance with one or more embodiments. The image generator model 400 may be configured to generate a predicted AD image 420 from an AE image 415. In some embodiments, the predicted AD image 420 may be an AD image that corresponds to or is paired with the AE image 415 (e.g., the predicted AD image 420 is a prediction of how the patterned substrate may look like after the development stage when imaged by the image capture device at a location from which the AE image 415 is obtained). In some embodiments, the image generator model 400 may include one or more ML models that are trained to generate a predicted AD image using an AE image.

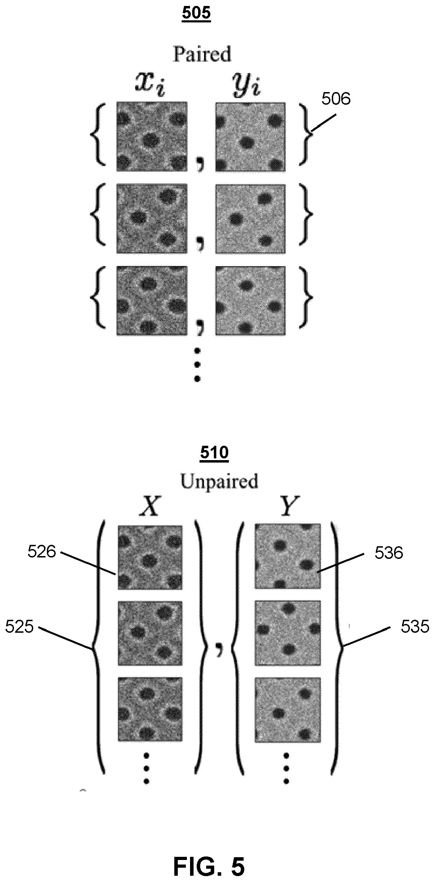

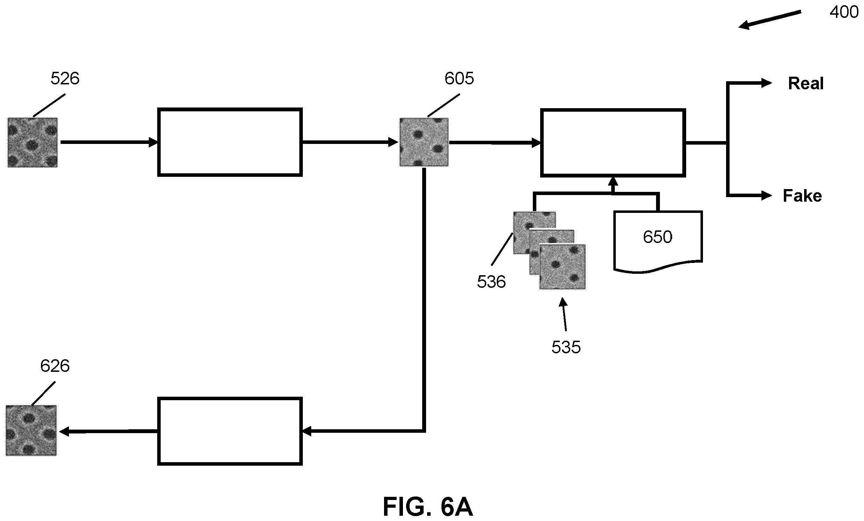

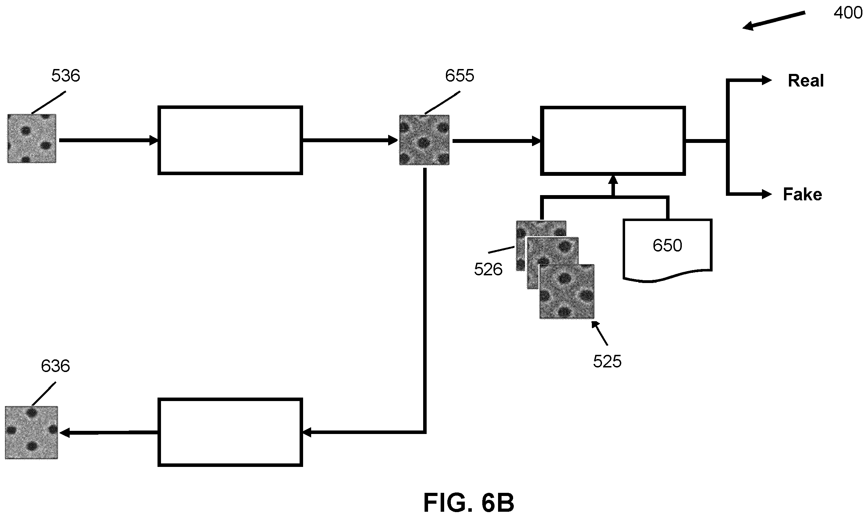

The image generator model 400 may be trained to generate the predicted AE image 410 (or predicted AD image 420) using multiple AD images and AE images as training data. FIG. 5 illustrates a training dataset, in accordance with one or more embodiments. The training data may include unpaired dataset 510 in which AE images 535 and AD images 525 are obtained from different locations (e.g., every AE image is obtained from a location different than all the locations from which the AD images are obtained). For example, an AE image 536 may be obtained from a location different than any of the AD images 525 is obtained from. In some embodiments, the training data may also include paired image dataset 505 in which each AD and AE image pair is obtained from the same location on the substrate. For example, the AE image and the AD image in the image pair 506 are obtained from the same location on the substrate. As described above, in some embodiments, the images in the datasets 505 and 510 may be obtained using an image capture device, such as a SEM illustrated in FIGS. 12-13. The details of training the image generator model 400 to generate the predicted AE image 410 (or the predicted AD image 420) are discussed in detail at least with reference to FIGS. 6A and 6B below.

FIGS. 6A and 6B are block diagrams of training an image generator model to predict an AE image or an AD image, in accordance with one or more embodiments. In some embodiments, the image generator model 400 is an ML model, such as a Cycle-consistent Generative Adversarial Network (Cycle GAN), which may be a variation of Generative Adversarial Network (GAN). The GAN architecture may include two different models called a generator model and a discriminator model that are trained in a cooperative manner. For example, the discriminator model is trained using an output from the generator model and an image from a target domain (or a plurality of images from a target domain), which is a domain to which the input image to the generator model has to be converted, or in other words, an image that is to be generated by the generator model. The discriminator model may be trained to identify (e.g., determine or classify) an input as "real" or "fake." A "real" input is an image that may be indistinguishable from images in a target domain and/or has one or more features that satisfy a specified criterion, and a "fake" input may be one that does not match with any of the images in the target domain or that does not satisfy the specified criterion. Typically, the discriminator is trained to classify the images from the target domain as real and images that are not from the target domain (e.g., images generated by the generator model) as fake. The generator model may be trained to improve the generated image so that the discriminator model may not classify the generated image as fake, and the discriminator model may be improved to discriminate the generated image against the images in the target domain so that the images that do not satisfy the specified criterion are not classified as "real." As the training progresses, the discriminator may not be able to distinguish the generated images from the images in the target domain anymore and may therefore, determine or classify the generated images as real. In some embodiments, the generator model and the discriminator model may be two separate convolutional neural networks (CNNs).

In some embodiments, in image-to-image translation neural networks the goal may be to learn the mapping between an input image and an output image using a training set of aligned image pairs. In a paired training set, every image, say "$img_A$" from input domain A, is manually mapped to some image, say "$img_B$" from target domain B, such that they share various features. Features can be used to map an image ($img_A$/$img_B$) to its correspondingly mapped counterpart ($img_B$/$img_A$). Basically, pairing is done to make input and output share some common features. This mapping defines meaningful transformation of an image from one domain (e.g., domain A) to another domain (e.g., domain B). So, when a paired training dataset is available, generator may take an input, say "$input_A$," from domain "$D_A$" and map this image to an output image, say "$gen_B$", which may be close to its mapped counterpart. However, for many tasks, training dataset having paired images or aligned images may not be available, and therefore, such pre-defined meaningful transformation is not readily available in unpaired training dataset.

In some embodiments, cycle GAN is one neural network architecture that generates such meaningful relation between input image and generated image that can be used to translate an image from one domain to another domain with unpaired training dataset. In some embodiments, a cycle GAN has two GANs and each GAN has its own generator and discriminator pair. In a cycle GAN, a first generator will map an input image (e.g., "$input_A$") from domain $D_A$ to some image in target domain "$D_B$." A second generator maps back this output image generated by the first generator back to the original input. For example, the cycle GAN inputs an image, $input_A$ (e.g., an input AD image 526 in FIG. 6A), from domain $D_A$ (e.g., AD images 525), to a first generator (e.g., AE generator model 455) which transforms the image $input_A$ to an image, $gen_B$ (e.g., predicted AE image 605), in target domain $D_B$ (e.g., AE images 535). This new generated image $gen_B$ (e.g., predicted AE image 605), is then fed to a second generator (e.g., AD generator model 465) which converts it back into an AD image, $cyclic_A$ (e.g., cyclic AD image 626), from the original domain $D_A$ (e.g., AD images 525). The cycle GAN continues to train the first generator until this output image, $cyclic_A$ (e.g., cyclic AD image 626), is close to the original input image, $input_A$ (e.g., AD image 526), to define a meaningful mapping that can be used in translating an image from one domain to another domain using an unpaired dataset. Once the $cyclic_A$ (e.g., cyclic AD image 626), is close to the original input image, $input_A$ (e.g., AD image 526), the first generator is considered to be "trained" and may be used to generate a predicted image from domain $D_B$ (e.g., predicted AE image) for any given image from domain $D_A$ (e.g., AD image).

The image generator model 400 may include multiple models, e.g., an AE generator model 455, an AE discriminator 460, an AD generator model 465, and an AD discriminator 470, each of which in some embodiments may be implemented using a CNN. The models may be trained using a training dataset (e.g., illustrated in FIG. 5). It should be noted that while at least some of the AD images and the reference AE images in the training dataset 510 are unpaired images, the training dataset 510 may also include paired AD and AE images.

FIG. 6A is a block diagram of training an image generator model to predict an AE image, in accordance with one or more embodiments. The AE generator model 455 may take as input an input AD image 526 and output a predicted AE image 605. The AE discriminator 460 may take as input the predicted AE image 605 and determine whether the predicted AE image 605 is real or fake.

In some embodiments, the AE discriminator 460 may also obtain one or more process-related parameters from the predicted AE image 605 and compare them with key performance indicators (KPIs) 650 input to the AE discriminator 460 to determine whether the predicted AE image 605 is real or fake. For example, a KPI may include one or more parameters associated with forming a pattern on the substrate, such as EPE, LEPE, SEPE, CD, CDU, LCDU, line thickness, or other metrology data. The AE discriminator 460 may determine the predicted AE image 605 as a real image if the AE discriminator 460 is not able to distinguish the predicted AE image 605 from the AE images 535 and the one or more process-related parameters satisfy the KPIs, else may determine the predicted AE image 605 as a fake image.

In some embodiments, the AE discriminator 460 may output numerical values of a certain range (e.g., 0 to 1 or -1 to 1) that are indicative of a real or fake image. For example, a value of "1" may indicate a real image and a value of "0" may indicate a fake image. In some embodiments, the closer the value to "1" the more real the image is and the closer the value "0," the more fake the image is. In some embodiments, a value above a specified threshold (e.g., "0.7") can be indicative of a real image, and below the specified threshold can be indicative of a fake image. In some embodiments, the predicted AE image 605 may be input to the AD generator model 465 to generate an AD image, e.g., a cyclic AD image 626, back from the predicted AE image 605. The cyclic AD image 626 may be used to determine if the predicted AE image 605 is accurate enough to generate the input AD image 526 back. During the training, in some embodiments, the AE discriminator 460 is trained to distinguish the predicted AE image 605 as fake and the AE generator model 455 is trained to generate the predicted AE image 605 such that the AE discriminator 460 may not distinguish the predicted AE image 605 as fake and the predicted AE image 605 is accurate enough to generate the input AD image 526 back. As the training progresses (e.g., more and more AD images and/or reference AE images are processed), the AE generator model 455 may succeed in generating the predicted AE image 605 that is indistinguishable from the AE images 535 such that the AE discriminator 460 may not classify the predicted AE image 605 as fake anymore.

In some embodiments, the training process of the image generator model 400 is an iterative process and an iteration can include receiving an input AD image from the set of AD images (e.g., input AD image 526 from the AD images 525), generating a predicted AE image (e.g., the predicted AE image 605), generating a cyclic AD image from the predicted AE image (e.g., cyclic AD image 626), computing a first cost function associated with generating the predicted AE image, and adjusting model parameters, such as weights and biases of the image generator model 400, based on the first cost function. In some embodiments, the first cost function may be defined as a function of the predicted AE images being determined as fake, the AE images 535 being determined as real, whether the predicted AE images satisfy the KPIs 650, and a difference between the cyclic AD image 626 and the input AD image 526. For example, the first cost function may be represented as:

$$L_1(AE) = E_{x \sim p_{data}(x)}\big[\log\big(1 - D_Y(G_X(x))\big)\big] + E_{y \sim p_{data}(y)}\big[\log D_Y(y)\big] +$$

$$E_{x \sim p_{data}(x)}\big[\|G_Y(G_X(x)) - x\|\big] \quad \ldots (1)$$

where x is a set of AD images 525 and y is a set of AE images 535, $x \sim p_{data}(x)$ and $y \sim p_{data}(y)$ denote the data distribution of the images, Gx(x) denotes a function translating an AD image to AE image, $D_Y(y)$ denotes the discrimination function for discriminating a predicted AE image;

$E_{x \sim p_{data}(x)}[\log(1 - D_Y(G_X(x)))] + E_{y \sim p_{data}(y)}[\log D_Y(y)]$ denotes the predicted AE images being determined as fake and the AE images 535 being determined as real; and

$E_{x \sim p_{data}(x)}[\|G_Y(G_X(x)) - x\|]$ denotes the difference between the cyclic AD image 626 and the input AD image 526, which is also referred to as a forward cycle consistency loss, - for each AD image, x, the image translation cycle should be able to bring the predicted AE image 605, Gx(x), back to the original image ($G_Y(G_X(x))$), i.e., x → $G_X(x)$ → $G_Y(G_X(x)) \approx x$.

Continuing with the iteration of the training process, for example, the AE discriminator 460 may determine the predicted AE image 605 as real but the third metric may indicate that a match between the cyclic AD image 626 and the input AD image 526 is below a match threshold. As this is an undesired result, one or more model parameters (e.g., weights and biases) of the AE discriminator 460 may have to be adjusted so that the predicted AE image 605 is distinguished as fake. Further, one or more model parameters of the AE generator model 455 may also have to be adjusted to improve the quality of the predicted AE image 605 such that a difference between the cyclic AD image 626 and the input AD image 526 is minimized. In some embodiments, the lesser the difference between the input AD image 526 and the cyclic AD image 626 the more accurate is the predicted AE image 605. Any of various methods for image comparison may be used to quantify the difference between the two images (e.g., pixel to pixel comparison). In some embodiments, adjusting of the model parameter(s) of the AE generator model 455 or the AE discriminator 460 is performed based on the first cost function (e.g., AE generator model 455 model parameters adjusted to minimize the first cost function and AE discriminator model 460 model parameters adjusted to maximize the first cost function).

Consequently (e.g., as the iterations are repeated with different AD and AE images), the first cost function may reduce and the AE generator model 455 will progressively generate predicted AE images that are more and more realistic or are similar to AE images 535 (and satisfy the KPIs 650), and the AE discriminator 460 will progressively get better at distinguishing a fake image (e.g., predicted AE image 605) from a real image (e.g., AE images 535). In some embodiments, the AE generator model 455 and the AE discriminator 460 are trained simultaneously, until the AE generator model 455 and the AE discriminator 460 may not improve each other. For example, if the first cost function is minimized, or do not change substantially over further iterations, the models do not improve each other, and therefore, may be considered as "trained" models. The trained AE generator model 455 may be used to generate a predicted AE image for any given AD image, as described at least with reference to FIG. 4A.

Similarly, referring to FIG. 6B, the AD generator model 465 and the AD discriminator 470 may also be trained to get better at generating a predicted AD image from an AE image. FIG. 6B is a block diagram of training an image generator model to predict an AD image, in accordance with one or more embodiments. In the training process, the AD generator model 465 receives an AE image (e.g., reference AE image 536 from AE images 535) as input and generates a predicted AD image 655 as output. The AD discriminator 470 receives the predicted AD image 655 as input, and determines whether the predicted AD image 655 is fake or real. In some embodiments, the predicted AD image 655 may be input to the AE generator model 455 to generate an AE image, e.g., a cyclic AE image 636, back from the predicted AD image 655. The cyclic AE image 636 may be used to determine if the predicted AD image 655 is accurate enough to generate the reference AE image 536 back. During the training, in some embodiments, the AD discriminator 470 is trained to determine or classify the predicted AD image 655 as fake, and the AD generator model 465 is trained to generate the predicted AD image 655 such that the AD discriminator 470 may not determine or classify the predicted AD image 655 as fake and the predicted AD image 655 is accurate enough to generate the reference AE image 536 back. As the training progresses (e.g., more and more AD images and/or reference AE images are processed), the AD generator model 465 may succeed in generating the predicted AD image 655 that is similar to one or more of the input AD images 525 such that the AD discriminator 470 may not distinguish the predicted AD image 655 as fake anymore.

As described above with reference to FIG. 6A, training the AD generator model 465 and the AD discriminator 470 is an iterative process and an iteration may include receiving an AE image from the set of AE images (e.g., reference AE image 536 from the AE images 535) as an input, generating a predicted AD image (e.g., the predicted AD image 655) using the input AE image, generating a cyclic AE image from the predicted AD image (e.g., cyclic AE image 636), computing a second cost function associated with generating the predicted AD image, and adjusting model parameters, such as weights and biases of the image generator model 400, based on the second cost function. In some embodiments, the second cost function may be defined as a function of (i) the predicted AD images being determined as fake and the input AD images 525 being determined as real, (ii) whether the predicted AD image 655 satisfies the KPIs 650, and (iii) a difference between the cyclic AE image 636 and the reference AE image 536. For example, the second cost function may be represented as:

$$L_2(AD) = E_{y \sim p_{data}(y)} \left[ \log \left( 1 - D_X \left( G_Y(y) \right) \right) \right] + E_{x \sim p_{data}(x)} [\log D_X(x)]$$

$$+ E_{y \sim p_{data}(y)} \left[ \left\| G_X \left( G_Y(y) \right) - y \right\| \right] \dots (2)$$

where F(y) denotes a function translating an AE image to AD image, $D_X(x)$ denotes the discrimination function for discriminating a predicted AD image;

$E_{y \sim p_{data}(y)}[\log(1 - D_X(G_Y(y)))] + E_{x \sim p_{data}(x)}[\log D_X(x)]$ denotes the predicted AD images being determined as fake and the input AD images 525 being determined as real; and

$E_{y \sim p_{data}(y)}[\|G_X(G_Y(y)) - y\|]$ denotes the difference between the cyclic AE image 636 and the reference AE image 536, which is a backward cycle consistency loss - for each AE image, y, the image translation cycle should be able to bring the predicted AD image 655, $G_Y(y)$, back to the original image $(G_X(G_Y(y)))$, i.e., $y \rightarrow G_Y(y) \rightarrow G_X(G_Y(y)) \approx y$.

As the iterations are repeated with different AD and AE images by adjusting model parameters to reduce the second cost function, the AD generator model 465 will progressively generate predicted AD images that are more and more realistic or are similar to the input AD images 525 (and satisfy the KPIs 650), and the AD discriminator 470 will progressively get better at distinguishing a fake image (e.g., predicted AD image 655) from a real image (e.g., input AD images 525). In some embodiments, the AD generator model 465 and the AD discriminator 470 are trained simultaneously, until the AD generator model 465 and the AD discriminator 470 may not improve each other. For example, if the second cost function is minimized, or do not change substantially over further iterations, the models may not improve each other, and therefore, may be considered as "trained" models. The trained AD generator model 465 may be used to generate a predicted AD image for any given AE image, as described at least with reference to FIG. 4B.

In some embodiments, training the image generator model 400 may include training the AE generator model 455, AE discriminator 460, AD generator model 465 or AD discriminator 470 until an overall cost function, which may be a function of the first cost function and the second cost function, is minimized. As an example, the overall cost function, *f*, of the image generator model 400 may be expressed as:

$$f(L_1, L_2) =$$

$$E_{x \sim p_{data}(x)} \left[ \log \left( 1 - D_Y \left( G_X(x) \right) \right) \right] + E_{y \sim p_{data}(y)} \left[ \log D_Y(y) \right]$$

$$+$$

$$E_{y \sim p_{data}(y)} \left[ \log \left( 1 - D_X \left( G_Y(y) \right) \right) \right] + E_{x \sim p_{data}(x)} \left[ \log D_X(x) \right]$$

$$+$$

$$\lambda \left( E_{x \sim p_{data}(x)} \left[ \left\| G_Y \left( G_X(x) \right) - x \right\| \right] + E_{y \sim p_{data}(y)} \left[ \left\| G_X \left( G_Y(y) \right) - y \right\| \right] \right) \quad \ldots \ldots \ldots (3)$$

where $\lambda$ is a constant.

In some embodiments, the overall cost function, *f*, (eq. 3) of the image generator model 400 is a combination of the equations (1) and (2) above. In some embodiments, the AE generator model 455, AE discriminator 460, AD generator model 465 or AD discriminator 470 are co-operatively trained such that the overall cost function of the image generator model 400 (eq. 3) does not improve anymore (e.g., is reduced, minimized, or below a specified threshold). For example, if values of the cost function do not change substantially over further iterations, the image generator model 400 may be considered as a trained model. In other words, the image generator model 400 is configured to generate predicted AE images or predicted AD images that are realistic or similar to actual AE images or AD images, respectively, or that satisfy respective criterion to be considered as real. The trained image generator model 400 can then be used to generate a predicted AE image from a given AD image, or a predicted AD image from a given AE image.

While the foregoing description describes the image generator model 400 being implemented using a cycle GAN ML model, the image generator model 400 is not limited to cycle GAN. The image generator model 400 may be implemented using other ML models, or prediction models (e.g., statistical models or other analytics models).

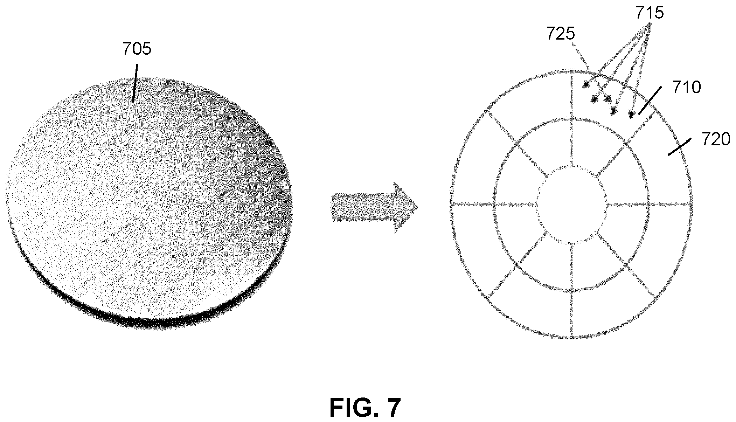

FIG. 7 schematically depicts preparation of a training dataset for training an image generator model, in accordance with one or more embodiments. In some embodiments, the results of a lithographic process may vary across a substrate 705. Accordingly, the across-substrate variation may impact the prediction AD or AE images. For example, a predicted AE image generated for a first location on the substrate 705 may be accurate, but another predicted AE image generated for a second location may not be accurate. In order to minimize the impact on image prediction from such across-substrate variations, the substrate 705 may be divided into a number of regions based on a specified criterion and a separate image generator model may be trained for each of those regions. For example, the substrate 705 may be divided into a number of regions based on etch variations (e.g., a first region 710 and a second region 720) such that etch variations within a region is minimum (e.g., below a specified threshold) to none. A first image generator model (e.g., the image generator model 400) may be trained for the first region 710, and a second image generator model may be trained for the second region 720 and so on. The first image generator model may be trained for the first region 710 using AD and AE images (e.g., unpaired AD and AE images) obtained from various locations 715 within the first region 710, and the second image generator model may be trained for the second region 720 using AD and AE images (e.g., unpaired AD and AE images) obtained from various locations within the second region. In some embodiments, an image generator model may be used to generate a predicted AD or AE image for the region of the substrate 705 for which the image generator model is trained. For example, a trained first image generator model may be used to generate a predicted AD or AE image for any location, e.g., location 725, in the first region 710, and the trained second image generator model may be used to generate a predicted AD or AE image for any location in the second region 720. In some embodiments, during prediction, a region identifier (e.g., region number) may be provided to the image generator model to select an appropriate model (e.g., model corresponding to the region) to generate the predicted AD or AE image.

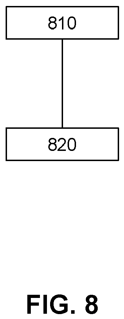

FIG. 8 is a flow diagram of a process for training an image generator model configured to generate a predicted AE image (and/or a predicted AD image), in accordance with one or more embodiments. At operation 810, a set of unpaired AD and AE images associated with a substrate are obtained. For example, unpaired AE and AD images, such as the unpaired dataset 510, are images that are obtained from different locations (e.g., every AE image is obtained from a location different than all the locations from which the AD images are obtained). However, in some embodiments, the paired AD and AE images, such as dataset 505, may also be used with the unpaired AD and AE images for training the image generator model.

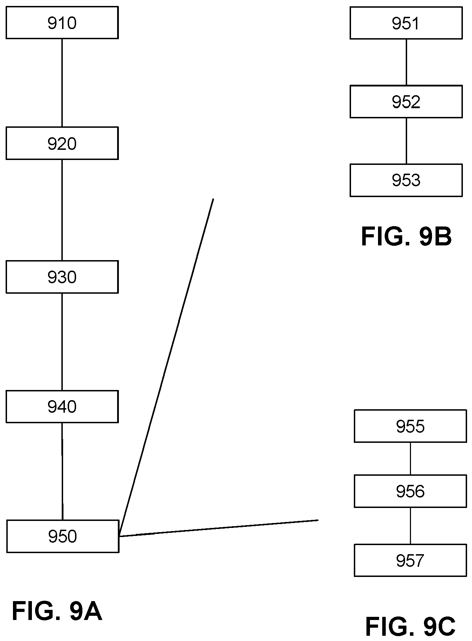

At operation 820, the image generator model is trained using the set of unpaired AD and AE images to generate a predicted AE image from an input AD image. For example, the image generator model 400 is trained to generate the predicted AE image 605 using the input AD image 526. In some embodiments, the predicted AE image 605 is a prediction of how the after-etch image may look like when imaged by the image capture device at a location on the substrate from which the input AD image 526 is obtained. Additional details of the training process are described at least with reference to FIGS. 9A-9C.

While the foregoing description is focused on training the image generator model 400 to generate a predicted AE image from an input AD image, it should be noted that, at least in some embodiments, training the image generator model 400 to generate the predicted AE image may also train the image generator model 400 to generate a predicted AD image from an input AE image (e.g., as described at least with reference to FIG. 6B above).

Figure 9A is a flow diagram of another process for training the image generator model to generate a predicted AE image or a predicted AD image, in accordance with one or more embodiments. In some embodiments, the method of FIG. 9A is performed as part of operation 820 of FIG. 8.

At operation 910, a predicted AE image is generated using an input AD image by an AE generator model of the image generator model. For example, the AE generator model 455 is executed to generate the predicted AE image 605 from the input AD image 526. In some embodiments, the AE generator model 455 is a CNN that takes an input vector (e.g., input AD image 526) and generates an output vector (e.g., predicted AE image 605).

At operation 920, an AE discriminator model of the image generator model determines whether the predicted AE image is real or fake. For example, the AE discriminator 460 takes as input the predicted AE image 605 generated by the AE generator model 455 and determines whether the predicted AE image 605 is real or fake. In some embodiments, the AE discriminator 460 is a CNN that takes an input vector (e.g., predicted AE image 605, KPIs 650) and generates an output value (e.g., "0" or "1", a value in a specified range "0"-"1") that is indicative of whether an image is real or fake. In some embodiments, the AE discriminator 460 may determine the predicted AE image 605 to be real if the AE discriminator 460 is not able to distinguish the predicted AE images from the reference AE images, and the one or more process-related parameters derived from the predicted AE image 605 satisfy the KPIs, else may determine the predicted AE image 605 to be fake.

At operation 930, an AD generator model of the image generator model is executed to generate a predicted AD image from the reference AE image. For example, the AD generator model 465 takes as input a reference AE image 536 and generates the predicted AD image 655 from the reference AE image 536. In some embodiments, the predicted AD image 655 is a prediction of how the after-development image of a location on the substrate from which the reference AE image 536 is obtained may look like when imaged by the image capture device. In some embodiments, the AD generator model 465 is a CNN that takes an input vector (e.g., reference AE image 536) and generates an output vector (e.g., predicted AD image 655).

At operation 940, an AD discriminator of the image generation model determines whether the predicted AD image is real or fake (e.g., in a way similar to the AE discriminator model described above at least with reference to operation 920). For example, the AD discriminator 470 takes as input the predicted AD image 655 generated by the AD generator model 465 and determines whether the predicted AD image 655 is real or fake. In some embodiments, the AD discriminator 470 is a CNN that takes an input vector (e.g., predicted AD image 655 or input AD image 526) and generates an output value (e.g., "0" or "1", a value in a specified range "0"-"1") that is indicative of whether an image is real or fake.

At operation 950, based on the output of the AE discriminator 460 or the AD discriminator 470, model parameters of the image generator model are adjusted based on a cost function associated with the image generator model. In some embodiments, the cost function includes a first cost function associated with the generation of the predicted AE image 605, and a second cost function associated with the generation of the predicted AD image 655.

FIG. 9B is a flow diagram of a method for minimizing a first cost function associated with generating a predicted AE image, in accordance with one or more embodiments. In some embodiments, the method of FIG. 9B is performed as part of operation 950 of FIG. 9A.

At operation 951, an AD image, e.g., a cyclic AD image 626, is generated back from the predicted AE image 605 using the AD generator model 465, which may be used to determine if the predicted AE image 605 is accurate enough to generate the input AD image 526 back.

At operation 952, a first cost function associated with generating the predicted AE image is computed. In some embodiments, the first cost function (e.g., eq. 1) may be defined as a function of (i) the predicted AE images being determined as fake and the AE images 535 being determined as real, (ii) whether the predicted AE images satisfy the KPIs 650, and (iii) a difference between the cyclic AD image 626 and the input AD image 526.

At operation 953, model parameters of the AE generator model 455 or the AE discriminator 460 may be adjusted based on the first cost function. For example, if the AE discriminator 460 determines the predicted AE image 605 to be real but the third metric may indicate that a match between the cyclic AD image 626 and the input AD image 526 is below a match threshold. As this is an undesired result, one or more model parameters (e.g., weights and biases) of the AE discriminator 460 may have to be adjusted (e.g., to maximize the first cost function) so that the predicted AE image 605 is distinguished as fake. Further, one or more model parameters of the AE generator model 455 may also have to be adjusted (e.g., to minimize the first cost function) to improve the quality of the predicted AE image 605 such that a difference between the cyclic AD image 626 and the input AD image 526 is minimized. Accordingly, the model parameters of the AE generator model 455 or the AE discriminator 460 may have to be adjusted based on the first cost function to make the AE generator model 455 generate an improved predicted AE image 605 such that the AE discriminator 460 does not determine the predicted AE image 605 as fake anymore.

FIG. 9C is a flow diagram of a method for minimizing a second cost function associated with generating a predicted AD image, in accordance with one or more embodiments. In some embodiments, the method of FIG. 9C is performed as part of operation 950 of FIG. 9A.

At operation 955, an AE image, e.g., a cyclic AE image 636, is generated back from the predicted AD image 655 using the AE generator model 455, which may be used to determine if the predicted AD image 655 is accurate enough to generate the reference AE image 536 back.

At operation 956, a second cost function associated with generating the predicted AD image is computed. In some embodiments, the second cost function (e.g., eq. 2) may be defined as a function of (i) the predicted AD images being determined as fake and the input AD images 525 being determined as real, (ii) whether the predicted AD image 655 satisfies the KPIs 650, and (iii) a difference between the cyclic AE image 636 and the reference AE image 536.

At operation 957, model parameters of the AD generator model 465 or the AD discriminator 470 may be adjusted based on the second cost function. For example, if the AD discriminator 470 determines the predicted AD image 655 to be real but the sixth metric may indicate that a match between the cyclic AE image 636 and the reference AE image 536 is below a match threshold. As this is an undesired result, one or more model parameters (e.g., weights and biases) of the AD discriminator 470 may have to be adjusted (e.g., to maximize the second cost function) so that the predicted AD image 655 is distinguished as fake. Further, one or more model parameters of the AD generator model 465 may also have to be adjusted (e.g., to minimize the second cost function) to improve the quality of the predicted AD image 655 such that a difference between the cyclic AE image 636 and the reference AE image 536 is minimized. Accordingly, the model parameters of the AD generator model 465 or the AD discriminator 470 may have to be adjusted based on the second cost function to make the AD generator model 465 generate an improved predicted AD image 655 such that the AD discriminator 470 does not determine the predicted AD image 655 as fake anymore.

Referring to FIG. 9A, the operations 910-950 may be repeated with a number of input AD images 525 and reference AE images 535 with the model parameters of the AE generator model 455, the AE discriminator 460, the AD generator model 465 or the AD discriminator 470, being adjusted progressively until the cost function, f, (expressed using equation 3) associated with the image generator model 400 is minimized (in some embodiments, below a specified threshold), or does not reduce significantly any more.

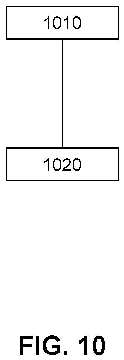

After the iterations are completed, the image generator model 400 is considered to be trained. The trained image generator model 400 can then be used to generate a predicted AE image from a given AD image and/or generate a predicted AD image from a given AE image, e.g., as described at least with reference to FIGS. 4A, 4B above, or FIG. 10 below.

FIG. 10 is a flow diagram of a process for generating a predicted AE image using an image generator model, in accordance with one or more embodiments. At operation 1010, an AD image associated with a specified location on a substrate is obtained. For example, an AD image 405 associated with a specified location on a substrate is obtained. In some embodiments, the AD image 405 is obtained from a location in a region of the substrate for which the image generator model 400 is trained. In some embodiments, the AD image is obtained using an image capture device such as a SEM tool. The AD image 405 may be input to the image generator model 400.

At operation 1020, an AE generator model of the image generator model generates a predicted AE image using the input AD image. For example, the AE generator model 455 generates the predicted AE image 410 using the AD image 405. In some embodiments, the predicted AE image 410 is a prediction of how the after-etch image of the substrate may look like when the substrate is imaged at the specified location using the image capture device.

Similar to the process discussed above, the image generator model 400 may also be used to generate a predicted AD image, such as the predicted AD image 420, by taking as input an AE image, such as the AE image 415. The AE image 415 may be an image generated from an image capture device of a specified location on the substrate. The predicted AD image 420 is a prediction of how the after-development image of the substrate may look like when the substrate is imaged at the specified location using the image capture device. Like in generating the predicted AE image 410, the image generator model 400 may, in some embodiments, use only a portion of the image generator model 400, such as the AD generator model 465, for generating the predicted AD image 420.

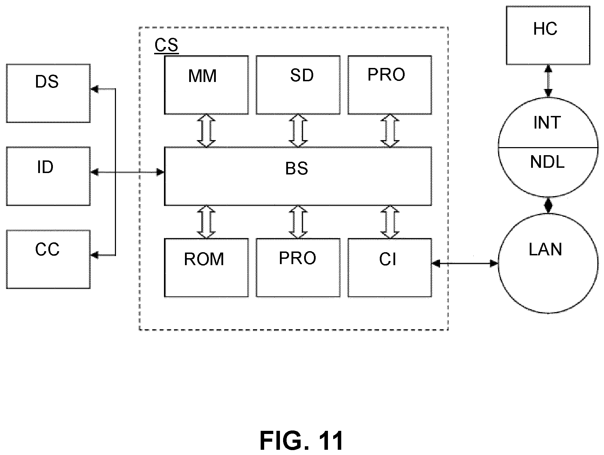

FIG. 11 is a block diagram of an example computer system CS which can assist in implementing the methods, flows, modules, components, or the apparatus disclosed herein, in accordance with one or more embodiments. Computer system CS includes a bus BS or other communication mechanism for communicating information, and a processor PRO (or multiple processor) coupled with bus BS for processing information. Computer system CS also includes a main memory MM, such as a random-access memory (RAM) or other dynamic storage device, coupled to bus BS for storing information and instructions to be executed by processor PRO. Main memory MM also may be used for storing temporary variables or other intermediate information during execution of instructions to be executed by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions contained in main memory MM causes processor PRO to perform the process steps described herein. One or more processors in a multi-processing arrangement may also be employed to execute the sequences of instructions contained in main memory MM. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the features described herein. Transitory computer-readable media can include a carrier wave or other propagating electromagnetic signal.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) both use electrical, electromagnetic or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

According to the present disclosure, the combination and sub-combinations of disclosed elements constitute separate embodiments. For example, the method for generating a predicted measured image and the method for aligning a measured image with the predicted measured image may comprise separate embodiments, and/or these methods may be used together in the same embodiment.

FIG. 12 schematically depicts an embodiment of an electron beam inspection apparatus 2320, according to an embodiment. In an embodiment, the inspection apparatus may be an electron beam inspection apparatus (e.g., the same as or similar to a scanning electron microscope (SEM)) that yields an image of a structure (e.g., some or all the structure of a device, such as an integrated circuit) exposed or transferred on the substrate. A primary electron beam 2324 emitted from an electron source 2322 is converged by condenser lens 2326 and then passes through a beam deflector 2328, an E x B deflector 2330, and an objective lens 2332 to irradiate a substrate 2310 on a substrate table 2312 at a focus.

When the substrate 2310 is irradiated with electron beam 2324, secondary electrons are generated from the substrate 2310. The secondary electrons are deflected by the E x B deflector 2330 and detected by a secondary electron detector 2334. A two-dimensional electron beam image can be obtained by detecting the electrons generated from the sample in synchronization with, e.g., two-dimensional scanning of the electron beam by beam deflector 2328 or with repetitive scanning of electron beam 2324 by beam deflector 2328 in an X or Y direction, together with continuous movement of the substrate 2310 by the substrate table 2312 in the other of the X or Y direction. Thus, in an embodiment, the electron beam inspection apparatus has a field of view for the electron beam defined by the angular range into which the electron beam can be provided by the electron beam inspection apparatus (e.g., the angular range through which the deflector 2328 can provide the electron beam 2324). Thus, the spatial extent of the field of the view is the spatial extent to which the angular range of the electron beam can impinge on a surface (wherein the surface can be stationary or can move with respect to the field).

A signal detected by secondary electron detector 2334 is converted to a digital signal by an analog/digital (A/D) converter 2336, and the digital signal is sent to an image processing system 2350. In an embodiment, the image processing system 2350 may have memory 2356 to store all or part of digital images for processing by a processing unit 2358. The processing unit 2358 (e.g., specially designed hardware or a combination of hardware and software or a computer readable medium comprising software) is configured to convert or process the digital images into datasets representative of the digital images. In an embodiment, the processing unit 2358 is configured or programmed to cause execution of a method described herein. Further, image processing system 2350 may have a storage medium 2352 configured to store the digital images and corresponding datasets in a reference database. A display device 2354 may be connected with the image processing system 2350, so that an operator can conduct necessary operation of the equipment with the help of a graphical user interface.

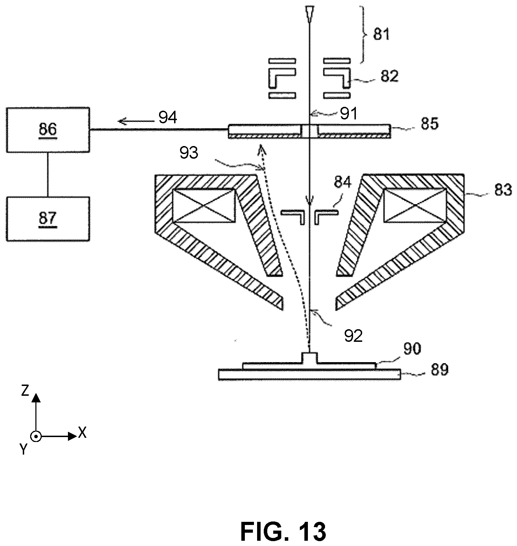

FIG. 13 schematically illustrates a further embodiment of an inspection apparatus, according to an embodiment. The system is used to inspect a sample 90 (such as a substrate) on a sample stage 88 and comprises a charged particle beam generator 81, a condenser lens module 82, a probe forming objective lens module 83, a charged particle beam deflection module 84, a secondary charged particle detector module 85, and an image forming module 86.

The charged particle beam generator 81 generates a primary charged particle beam 91. The condenser lens module 82 condenses the generated primary charged particle beam 91. The probe forming objective lens module 83 focuses the condensed primary charged particle beam into a charged particle beam probe 92. The charged particle beam deflection module 84 scans the formed charged particle beam probe 92 across the surface of an area of interest on the sample 90 secured on the sample stage 88. In an embodiment, the charged particle beam generator 81, the condenser lens module 82 and the probe forming objective lens module 83, or their equivalent designs, alternatives or any combination thereof, together form a charged particle beam probe generator which generates the scanning charged particle beam probe 92.

The secondary charged particle detector module 85 detects secondary charged particles 93 emitted from the sample surface (maybe also along with other reflected or scattered charged particles from the sample surface) upon being bombarded by the charged particle beam probe 92 to generate a secondary charged particle detection signal 94. The image forming module 86 (e.g., a computing device) is coupled with the secondary charged particle detector module 85 to receive the secondary charged particle detection signal 94 from the secondary charged particle detector module 85 and accordingly forming at least one scanned image. In an embodiment, the secondary charged particle detector module 85 and image forming module 86, or their equivalent designs, alternatives or any combination thereof, together form an image forming apparatus which forms a scanned image from detected secondary charged particles emitted from sample 90 being bombarded by the charged particle beam probe 92.

In an embodiment, a monitoring module 87 is coupled to the image forming module 86 of the image forming apparatus to monitor, control, etc. the patterning process and/or derive a parameter for patterning process design, control, monitoring, etc. using the scanned image of the sample 90 received from image forming module 86. So, in an embodiment, the monitoring module 87 is configured or programmed to cause execution of a method described herein. In an embodiment, the monitoring module 87 comprises a computing device. In an embodiment, the monitoring module 87 comprises a computer program to provide functionality herein and encoded on a computer readable medium forming, or disposed within, the monitoring module 87.

The embodiments may further be described using the following clauses:

1. A non-transitory computer-readable medium having instructions that, when executed by a computer, cause the computer to execute a method for training a machine learning model, the method comprising:

obtaining a set of unpaired after-development (AD) images and after-etch (AE) images associated with a substrate, wherein each AD image is obtained from a location on the substrate that is different from all locations at which the AE images are obtained; and
training the machine learning model to generate a predicted AE image based on the AD images and the AE images, wherein the predicted AE image corresponds to a location from which an input AD image of the AD images is obtained.

2. The computer-readable medium of clause 1, wherein training the machine learning model is an iterative process, and wherein each iteration includes:

generating, via an AE generator model of the machine learning model, the predicted AE image using the input AD image; and
determining, via an AE discriminator model of the machine learning model, whether the predicted AE image is classified as a real or fake image.

3. The computer-readable medium of clause 2, wherein determining whether the predicted AE image is classified as a real or fake image includes:

computing a first cost function that is indicative of predicted AE images being classified as fake and the AE images being classified as real, wherein the first cost function is further computed based on a set of process-related parameters;
adjusting parameters of the AE discriminator model to maximize the first cost function; and
adjusting parameters of the AE generator model to minimize the first cost function.

4. The computer-readable medium of clause 3 further comprising:

generating, via an AD generator model of the machine learning model, a cyclic AD image using the predicted AE image;
computing a second cost function that is indicative of a difference between the cyclic AD image and the input AD image; and
adjusting parameters of the AD generator model or the AE generator model to minimize the second cost function.

5. The computer-readable medium of clause 4, wherein the training includes training the machine learning model with a different AD image and AE image in each iteration until the AE discriminator model determines whether the predicted AE image is classified as a real image.

6. The computer-readable medium of clause 5, wherein the AE discriminator model determines whether the predicted AE image is classified as a real image when the first cost function or the second cost function is minimized.

7. The computer-readable medium of clause 3, wherein the set of process-related parameters includes parameters associated with one or more processes for forming a pattern on the substrate.

8. The computer-readable medium of clause 2, wherein the iteration includes:

generating, via an AD generator model of the machine learning model, a predicted AD image using a reference AE image of the AE images; and
determining, via an AD discriminator model of the machine learning model, whether the predicted AD image is classified as a real or fake image.

9. The computer-readable medium of clause 8, wherein determining whether the predicted AD image is classified as a real or fake image includes:

computing a third cost function that is indicative of predicted AD images being classified as fake and the AD images being classified as real, wherein the third cost function is further computed based on a set of process-related parameters;
adjusting parameters of the AD discriminator model to maximize the third cost function; and
adjusting parameters of the AD generator model to minimize the third cost function.

10. The computer-readable medium of clause 9 further comprising:

generating, via the AE generator model, a cyclic AE image using the predicted AD image;
computing a fourth cost function that is indicative of a difference between the cyclic AE image and the reference AE image; and
adjusting parameters of the AD generator model or the AE generator model to minimize the fourth cost function.

11. The computer-readable medium of clause 10, wherein the training includes training the machine learning model with a different AD image and AE image in each iteration until the AD discriminator model determines whether the predicted AD image is classified as a real image.

12. The computer-readable medium of clause 11, wherein the AD discriminator model determines whether the predicted AD image is classified as a real image when the third cost function or the fourth cost function is minimized.

13. The computer-readable medium of clauses 5 and 10, wherein the training includes training the machine learning model until (i) the first cost function, the second cost function, the third cost function, or the fourth cost function is minimized, or (ii) the AE discriminator model determines whether the predicted AE image is classified as a real image and the AD discriminator model determines whether the predicted AD image is classified as a real image.

14. The computer-readable medium of clause 1, wherein the substrate includes a plurality of regions, and wherein the set of unpaired AD and AE images are obtained from a same region of the regions.

15. The computer-readable medium of clause 1 further comprising:

receiving a new AD image associated with the substrate; and
generating, via the AE generator model, a new predicted AE image using the new AD image.

16. The computer-readable medium of clause 15 further comprising:

obtaining one or more parameters based on the new predicted AE image, wherein the one or more parameters are associated with an apparatus or a process for forming a pattern on the substrate; and
adjusting the apparatus or the process based on the one or more parameters.

17. The computer-readable medium of clause 15, wherein the new AD image is obtained from a same region of the substrate from which the set of unpaired AD and AE images are obtained to train the machine learning model.

18. The computer-readable medium of clause 1 further comprising:

receiving a new AE image associated with the substrate; and
generating, via the AD generator model, a new predicted AD image using the new AE image.

19. The computer-readable medium of clause 17, wherein the new AE image is obtained from a same region of the substrate from which the set of unpaired AD and AE images are obtained to train the machine learning model.

20. The computer-readable medium of clause 1 further comprising:

receiving, by the machine learning model, (a) a new AD image associated with a first substrate, and (b) an AE image associated with a second substrate; and
generating, by the machine learning model, a new predicted AE image using the new AD image, and (b) a new predicted AD image using the new AE image.

21. The computer-readable medium of clause 1, wherein the set of unpaired AD images and AE images are obtained from an image capture device and correspond to a pattern printed on the substrate.

22. A non-transitory computer-readable medium having instructions that, when executed by a computer, cause the computer to execute a method for training a machine learning model, the method comprising:

obtaining a set of unpaired after-development (AD) images and after-etch (AE) images associated with a substrate, wherein each AD image is obtained from a location on the substrate that is different from all locations at which the AE images are obtained; and
training the machine learning model to generate a predicted AE image, wherein the training includes:

training an AE generator model of the machine learning model to generate the predicted AE image from an input AD image of the AD images such that a first cost function determined based on the input AD image and the predicted AE image is reduced, and
training an AD generator model of the machine learning model to generate a predicted AD image from a reference AE image of the AE images such that a second cost function determined based on the reference AE image and the predicted AD image is reduced.

23. The computer-readable medium of clause 22, wherein the training the machine learning model is an iterative process, and wherein each iteration includes:

training the AE generator model by:

generating, via the AE generator model, the predicted AE image using the input AD image, and
determining, via an AE discriminator model of the machine learning model, whether the predicted AE image is classified as a real image or a fake image; and

training the AD generator model by:

generating, via the AD generator model, a predicted AD image using the reference AE image, and
determining, via an AD discriminator model of the machine learning model, whether the predicted AD image is classified as a real image or a fake image.

24. The computer-readable medium of clause 23, wherein determining whether the predicted AE image is classified as a real or fake image includes:

computing a first cost function that is indicative of predicted AE images being classified as fake and the AE images being classified as real, wherein the first cost function is further computed based on a set of process-related parameters;
adjusting parameters of the AE discriminator model to maximize the first cost function; and
adjusting parameters of the AE generator model to minimize the first cost function.

25. The computer-readable medium of clause 24 further comprising:

generating, via the AD generator model, a cyclic AD image using the predicted AE image;
computing the first cost function further based on a difference between the cyclic AD image and the input AD image; and
adjusting parameters of the AD generator model or the AE generator model to minimize the first cost function.

26. The computer-readable medium of clause 23, wherein determining whether the predicted AD image is classified as a real or fake image includes:

computing a second cost function that is indicative of predicted AD images being classified as fake and the AD images being classified as real, wherein the second cost function is further computed based on a set of process-related parameters;
adjusting parameters of the AD discriminator model to maximize the second cost function; and
adjusting parameters of the AD generator model to minimize the second cost function.

27. The computer-readable medium of clause 26 further comprising:

generating, via the AE generator model, a cyclic AE image using the predicted AD image;

computing the second cost function further based on a difference between the cyclic AE image and the reference AE image; and

adjusting parameters of the AD generator model or the AE generator model to minimize the second cost function.

28. The computer-readable medium of clause 23, wherein the training includes training the machine learning model until the AE discriminator model determines whether the predicted AE image is classified as a real image or the AD discriminator model determines whether the predicted AD image is classified as a real image.

29. The computer-readable medium of clause 22 further comprising:

receiving a new AD image associated with the substrate; and

generating, by the AE generator model, a new predicted AE image using the AD image.

30. The computer-readable medium of clause 22 further comprising:

receiving a new AE image associated with the substrate; and

generating, via the AD generator model, a new predicted AD image using the new AE image.

31. A non-transitory computer-readable medium having instructions that, when executed by a computer, cause the computer to execute a method for training a machine learning model, the method comprising:

obtaining a set of unpaired after-development (AD) images and after-etch (AE) images associated with a substrate, wherein each AD image is obtained from a location on the substrate that is different from all locations at which the AE images are obtained; and

training the machine learning model to generate a predicted AD image based on the AD images and the AE images, wherein the predicted AD image corresponds to a location from which an input AE image of the AE images is obtained.

32. A non-transitory computer-readable medium having instructions that, when executed by a computer, cause the computer to execute a method for training a machine learning model, the method comprising:

obtaining a set of unpaired after-development (AD) images and after-etch (AE) images associated with a substrate, wherein each AD image is obtained from a location on the substrate that is different from all locations at which the AE images are obtained; and

training the machine learning model to generate a predicted AE image and a predicted AD image based on the AD images and the AE images, wherein the predicted AE image corresponds to a location from which an input AD image of the AD images is obtained, and wherein the predicted AD image corresponds to a location from which an input AE image of the AE images is obtained.

33. The computer-readable medium of clause 32, wherein the training the machine learning model is an iterative process, and wherein each iteration includes:

generating, via the machine learning model, the predicted AE image using the input AD image; and

determining, via the machine learning model, whether the predicted AE image is classified as a real or fake image.

34. The computer-readable medium of clause 33, wherein determining whether the predicted AE image is classified as a real or fake image includes:

computing a first cost function that is indicative of predicted AE images being classified as fake and the AE images being classified as real, wherein the first cost function is further computed based on a set of process-related parameters; and

adjusting parameters of the machine learning model based on the first cost function.

35. The computer-readable medium of clause 34 further comprising:

generating, via the machine learning model, a cyclic AD image using the predicted AE image;

computing a second cost function that is indicative of a difference between the cyclic AD image and the input AD image; and

adjusting parameters of the machine learning model to minimize the second cost function.

36. The computer-readable medium of clause 35, wherein the training includes training the machine learning model with a different AD image and AE image in each iteration until the predicted AE image is classified as a real image.

37. The computer-readable medium of clause 36, wherein the machine learning model determines whether the predicted AE image is classified as a real image when the first cost function or the second cost function is minimized.

38. The computer-readable medium of clause 34, wherein the set of process-related parameters includes parameters associated with one or more processes for forming a pattern on the substrate.

39. The computer-readable medium of clause 35, wherein the iteration includes:

generating, via the machine learning model, the predicted AD image using a reference AE image of the AE images; and

determining, via the machine learning model, whether the predicted AD image is classified as a real or fake image based on the input AD image.

40. The computer-readable medium of clause 39, wherein determining whether the predicted AD image is classified as a real or fake image includes:

computing a third cost function that is indicative of predicted AD images being classified as fake and the AD images being classified as real, wherein the third cost function is further computed based on a set of process-related parameters; and

adjusting parameters of the machine learning model based on the third cost function.

41. The computer-readable medium of clause 40 further comprising:

generating, via the machine learning model, a cyclic AE image using the predicted AD image;

computing a fourth cost function that is indicative of a difference between the cyclic AE image and the reference AE image; and

adjusting parameters of the machine learning model to minimize the fourth cost function.

42. The computer-readable medium of clause 41, wherein the training includes training the machine learning model with a different AD image and AE image in each iteration until the predicted AD image is classified as a real image.

43. The computer-readable medium of clause 42, wherein the machine learning model determines whether the predicted AD image is classified as a real image when the third cost function or the fourth cost function is minimized.

44. The computer-readable medium of clause 32 further comprising:

receiving a new AD image associated with the substrate; and

generating, via the machine learning model, a new predicted AE image using the new AD image.

45. The computer-readable medium of clause 44 further comprising:

obtaining one or more parameters based on the new predicted AE image, wherein the one or more parameters are associated with an apparatus or a process for forming a pattern on the substrate; and

adjusting the apparatus or the process based on the one or more parameters.

46. The computer-readable medium of clause 32 further comprising:

receiving a new AE image associated with the substrate; and

generating, via the machine learning model, a new predicted AD image using the new AE image.

47. A method for training a machine learning model, the method comprising:

obtaining a set of unpaired after-development (AD) images and after-etch (AE) images associated with a substrate, wherein each AD image is obtained from a location on the substrate that is different from all locations at which the AE images are obtained; and

training the machine learning model to generate a predicted AE image based on the AD images and the AE images, wherein the predicted AE image corresponds to a location from which an input AD image of the AD images is obtained.

48. The method of clause 47, wherein the training the machine learning model is an iterative process, and wherein each iteration includes:

generating, via an AE generator model of the machine learning model, the predicted AE image using the input AD image; and
determining, via an AE discriminator model of the machine learning model, whether the predicted AE image is classified as a real or fake image.

49. The method of clause 48, wherein determining whether the predicted AE image is classified as a real or fake image includes:

computing a first cost function that is indicative of predicted AE images being classified as fake and the AE images being classified as real, wherein the first cost function is further computed based on a set of process-related parameters;
adjusting parameters of the AE discriminator model to maximize the first cost function; and
adjusting parameters of the AE generator model to minimize the first cost function.

50. The method of clause 49 further comprising:

generating, via an AD generator model of the machine learning model, a cyclic AD image using the predicted AE image;
computing a second cost function that is indicative of a difference between the cyclic AD image and the input AD image; and
adjusting parameters of the AD generator model or the AE generator model to minimize the second cost function.

51. The method of clause 50, wherein the training includes training the machine learning model with a different AD image and AE image in each iteration until the AE discriminator model determines whether the predicted AE image is classified as a real image.

52. The method of clause 51, wherein the AE discriminator model determines whether the predicted AE image is classified as a real image when the first cost function or the second cost function is minimized.

53. The method of clause 49, wherein the set of process-related parameters includes parameters associated with one or more processes for forming a pattern on the substrate.

54. The method of clause 48, wherein the iteration includes:

generating, via an AD generator model of the machine learning model, a predicted AD image using a reference AE image of the AE images; and
determining, via an AD discriminator model of the machine learning model, whether the predicted AD image is classified as a real or fake image.

55. The method of clause 54, wherein determining whether the predicted AD image is classified as a real or fake image includes:

computing a third cost function that is indicative of predicted AD images being classified as fake and the AD images being classified as real, wherein the third cost function is further computed based on a set of process-related parameters;
adjusting parameters of the AD discriminator model to maximize the third cost function; and
adjusting parameters of the AD generator model to minimize the third cost function.

56. The method of clause 55 further comprising:

generating, via the AE generator model, a cyclic AE image using the predicted AD image;
computing a fourth cost function that is indicative of a difference between the cyclic AE image and the reference AE image; and
adjusting parameters of the AD generator model or the AE generator model to minimize the fourth cost function.

57. The method of clause 56, wherein the training includes training the machine learning model with a different AD image and AE image in each iteration until the AD discriminator model determines whether the predicted AD image is classified as a real image.

58. The method of clause 57, wherein the AD discriminator model determines whether the predicted AD image is classified as a real image when the third cost function or the fourth cost function is minimized.

59. The method of clause 47, wherein the substrate includes a plurality of regions, and wherein the set of unpaired AD and AE images are obtained from a same region of the regions.

60. The method of clause 47 further comprising:

receiving a new AD image associated with the substrate; and
generating, via the AE generator model, a new predicted AE image using the new AD image.

61. The method of clause 60 further comprising:

obtaining one or more parameters based on the new predicted AE image, wherein the one or more parameters are associated with an apparatus or a process for forming a pattern on the substrate; and
adjusting the apparatus or the process based on the one or more parameters.

62. The method of clause 60, wherein the new AD image is obtained from a same region of the substrate from which the set of unpaired AD and AE images are obtained to train the machine learning model.

63. The method of clause 47 further comprising:

receiving a new AE image associated with the substrate; and
generating, via the AD generator model, a new predicted AD image using the new AE image.

64. The method of clause 63, wherein the new AE image is obtained from a same region of the substrate from which the set of unpaired AD and AE images are obtained to train the machine learning model.

65. The method of clause 47 further comprising:

receiving, by the machine learning model, (a) a new AD image associated with a first substrate, and (b) an AE image associated with a second substrate; and
generating, by the machine learning model, a new predicted AE image using the new AD image, and (b) a new predicted AD image using the new AE image.

66. The method of clause 47, wherein the set of unpaired AD images and AE images are obtained from an image capture device and correspond to a pattern printed on the substrate.

67. A method for training a machine learning model, the method comprising:

obtaining a set of unpaired after-development (AD) images and after-etch (AE) images associated with a substrate, wherein each AD image is obtained from a location on the substrate that is different from all locations at which the AE images are obtained; and
training the machine learning model to generate a predicted AD image based on the AD images and the AE images, wherein the predicted AD image corresponds to a location from which an input AE image of the AE images is obtained.

68. A method for training a machine learning model, the method comprising:

obtaining a set of unpaired after-development (AD) images and after-etch (AE) images associated with a substrate, wherein each AD image is obtained from a location on the substrate that is different from all locations at which the AE images are obtained; and
training the machine learning model to generate a predicted AE image and a predicted AD image based on the AD images and the AE images, wherein the predicted AE image corresponds to a location from which an input AD image of the AD images is obtained, and wherein the predicted AD image corresponds to a location from which an input AE image of the AE images is obtained.

69. An apparatus for training a machine learning model, the apparatus comprising:

a memory storing a set of instructions; and
at least one processor configured to execute the set of instructions to cause the apparatus to perform a method of:

obtaining a set of unpaired after-development (AD) images and after-etch (AE) images associated with a substrate, wherein each AD image is obtained from a location on the substrate that is different from all locations at which the AE images are obtained; and

training the machine learning model to generate a predicted AE image based on the AD images and the AE images, wherein the predicted AE image corresponds to a location from which an input AD image of the AD images is obtained.

70. The apparatus of clause 69, wherein training the machine learning model is an iterative process, and wherein each iteration includes:

generating, via an AE generator model of the machine learning model, the predicted AE image using the input AD image; and

determining, via an AE discriminator model of the machine learning model, whether the predicted AE image is classified as a real or fake image.

71. The apparatus of clause 70, wherein determining whether the predicted AE image is classified as a real or fake image includes:

computing a first cost function that is indicative of predicted AE images being classified as fake and the AE images being classified as real, wherein the first cost function is further computed based on a set of process-related parameters;

adjusting parameters of the AE discriminator model to maximize the first cost function; and

adjusting parameters of the AE generator model to minimize the first cost function.

72. The apparatus of clause 71 further comprising:

generating, via an AD generator model of the machine learning model, a cyclic AD image using the predicted AE image;

computing a second cost function that is indicative of a difference between the cyclic AD image and the input AD image; and

adjusting parameters of the AD generator model or the AE generator model to minimize the second cost function.

73. The apparatus of clause 72, wherein the training includes training the machine learning model with a different AD image and AE image in each iteration until the AE discriminator model determines whether the predicted AE image is classified as a real image.

74. The apparatus of clause 73, wherein the AE discriminator model determines whether the predicted AE image is classified as a real image when the first cost function or the second cost function is minimized.

75. The apparatus of clause 71, wherein the set of process-related parameters includes parameters associated with one or more processes for forming a pattern on the substrate.

76. The apparatus of clause 70, wherein the iteration includes:

generating, via an AD generator model of the machine learning model, a predicted AD image using a reference AE image of the AE images; and

determining, via an AD discriminator model of the machine learning model, whether the predicted AD image is classified as a real or fake image.

77. The apparatus of clause 76, wherein determining whether the predicted AD image is classified as a real or fake image includes:

computing a third cost function that is indicative of predicted AD images being classified as fake and the AD images being classified as real, wherein the third cost function is further computed based on a set of process-related parameters;

adjusting parameters of the AD discriminator model to maximize the third cost function; and

adjusting parameters of the AD generator model to minimize the third cost function.

78. The apparatus of clause 77 further comprising:

generating, via the AE generator model, a cyclic AE image using the predicted AD image;

computing a fourth cost function that is indicative of a difference between the cyclic AE image and the reference AE image; and

adjusting parameters of the AD generator model or the AE generator model to minimize the fourth cost function.

79. The apparatus of clause 78, wherein the training includes training the machine learning model with a different AD image and AE image in each iteration until the AD discriminator model determines whether the predicted AD image is classified as a real image.

80. The apparatus of clause 79, wherein the AD discriminator model determines whether the predicted AD image is classified as a real image when the third cost function or the fourth cost function is minimized.

81. The apparatus of clause 69, wherein the substrate includes a plurality of regions, and wherein the set of unpaired AD and AE images are obtained from a same region of the regions.

82. The apparatus of clause 69 further comprising:

receiving a new AD image associated with the substrate; and
generating, via the AE generator model, a new predicted AE image using the new AD image.

83. The apparatus of clause 82 further comprising:

obtaining one or more parameters based on the new predicted AE image, wherein the one or more parameters are associated with an apparatus or a process for forming a pattern on the substrate; and
adjusting the apparatus or the process based on the one or more parameters.

84. The apparatus of clause 82, wherein the new AD image is obtained from a same region of the substrate from which the set of unpaired AD and AE images are obtained to train the machine learning model.

85. The apparatus of clause 69 further comprising:

receiving a new AE image associated with the substrate; and
generating, via the AD generator model, a new predicted AD image using the new AE image.

86. The apparatus of clause 85, wherein the new AE image is obtained from a same region of the substrate from which the set of unpaired AD and AE images are obtained to train the machine learning model.

87. The apparatus of clause 69 further comprising:

receiving, by the machine learning model, (a) a new AD image associated with a first substrate, and (b) an AE image associated with a second substrate; and
generating, by the machine learning model, a new predicted AE image using the new AD image, and (b) a new predicted AD image using the new AE image.

88. The apparatus of clause 69, wherein the set of unpaired AD images and AE images are obtained from an image capture device and correspond to a pattern printed on the substrate.

89. An apparatus for training a machine learning model, the apparatus comprising:

a memory storing a set of instructions; and
at least one processor configured to execute the set of instructions to cause the apparatus to perform a method of:

obtaining a set of unpaired after-development (AD) images and after-etch (AE) images associated with a substrate, wherein each AD image is obtained from a location on the substrate that is different from all locations at which the AE images are obtained; and
training the machine learning model to generate a predicted AD image based on the AD images and the AE images, wherein the predicted AD image corresponds to a location from which an input AE image of the AE images is obtained.

90. An apparatus for training a machine learning model, the apparatus comprising:

a memory storing a set of instructions; and
at least one processor configured to execute the set of instructions to cause the apparatus to perform a method of:

obtaining a set of unpaired after-development (AD) images and after-etch (AE) images associated with a substrate, wherein each AD image is obtained from a location on the substrate that is different from all locations at which the AE images are obtained; and

training the machine learning model to generate a predicted AE image and a predicted AD image based on the AD images and the AE images, wherein the predicted AE image corresponds to a location from which an input AD image of the AD images is obtained, and wherein the predicted AD image corresponds to a location from which an input AE image of the AE images is obtained.

91. An apparatus for generating a first image from a second image using a machine learning model, the apparatus comprising:

a memory storing a set of instructions; and
at least one processor configured to execute the set of instructions to cause the apparatus to perform a method of:

obtaining a given after-development (AD) image associated with a given substrate, wherein the given AD image corresponds to a given location on the given substrate; and
generating, via a machine learning model, a given predicted after-etch (AE) image using the given AD image, wherein the given predicted AE image corresponds to the given location, wherein the machine learning model is trained to generate a predicted AE image using a set of unpaired AD images and AE images associated with a substrate.

92. The apparatus of clause 91, wherein each AD image in the set of unpaired AD images and AE images is obtained at a location on the substrate that is different from all locations at which the AE images are obtained.
93. The apparatus of clause 91, wherein generating the given predicted AE image includes:

training the machine learning model by:

generating, via the machine learning model, the predicted AE image using an input AD image of the AD images, and
determining, via the machine learning model, whether the predicted AE image is classified as a real image or a fake image.

94. The apparatus of clause 93, wherein determining whether the predicted AE image is classified a real or fake image includes:

computing a first cost function that is indicative of the predicted AE image being classified as fake and the AE images being classified as real, wherein the first cost function is further computed based on a set of process-related parameters; and
adjusting parameters of the machine learning model based on the first cost function.

95. The apparatus of clause 94 further comprising:

generating, via the machine learning model, a cyclic AD image using the predicted AE image;
computing the first cost function further based on a difference between the cyclic AD image and the input AD image; and
adjusting parameters of the machine learning model based on the first cost function.

96. The apparatus of clause 95, wherein the machine learning model is iteratively trained with a different AD image and AE image from the set of unpaired AD and AE images until the predicted AE image is classified as a real image or until the first cost function is minimized.
97. An apparatus for generating a first image from a second image using a machine learning model, the apparatus comprising:

a memory storing a set of instructions; and
at least one processor configured to execute the set of instructions to cause the apparatus to perform a method of:

obtaining a given after-etch (AE) image associated with a given substrate, wherein the given AE image corresponds to a given location on the given substrate; and
generating, via a machine learning model, a given predicted after-development (AD) image using the given AE image, wherein the given predicted AD image corresponds to the given location, wherein the machine learning model is trained to generate a predicted AD image using a set of unpaired AD images and AE images associated with a substrate.

98. A non-transitory computer readable medium having instructions recorded thereon, the instructions when executed by a computer implementing the method of any of the above clauses.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

While specific embodiments have been described above, it will be appreciated that the disclosure may be practiced otherwise than as described. For example, an embodiment may take the form of a computer program containing one or more sequences of machine-readable instructions describing a method as disclosed above, or a non-transitory data storage medium (e.g., semiconductor memory, magnetic or optical disk) having such a computer program stored therein, or a transitory medium having such a computer program therein. Further, the machine-readable instruction may be embodied in two or more computer programs. The two or more computer programs may be stored on one or more different data storage media.

Relative dimensions of components in drawings may be exaggerated for clarity. Within the description of drawings, the same or like reference numbers refer to the same or like components or entities, and only the differences with respect to the individual embodiments are described. As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

It will be appreciated that the embodiments of the present disclosure are not limited to the exact construction that has been described above and illustrated in the accompanying drawings, and that various modifications and changes may be made without departing from the scope thereof. The present disclosure has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

**Claims**

1. A non-transitory computer-readable medium having instructions that, when executed by a computer, cause the computer to execute a method for training a machine learning model, the method comprising:

    obtaining a set of unpaired after-development (AD) images and after-etch (AE) images associated with a substrate, wherein each AD image is obtained from a location on the substrate that is different from all locations at which the AE images are obtained; and
    training the machine learning model to generate a predicted AE image based on the AD images and the AE images, wherein the predicted AE image corresponds to a location from which an input AD image of the AD images is obtained.

2. The computer-readable medium of claim 1, wherein training the machine learning model is an iterative process, and wherein each iteration includes:

    generating, via an AE generator model of the machine learning model, the predicted AE image using the input AD image; and
    determining, via an AE discriminator model of the machine learning model, whether the predicted AE image is classified as a real or fake image.

3. The computer-readable medium of claim 2, wherein determining whether the predicted AE image is classified as a real or fake image includes:

    computing a first cost function that is indicative of predicted AE images being classified as fake and the AE images being classified as real, wherein the first cost function is further computed based on a set of process-related parameters;

adjusting parameters of the AE discriminator model to maximize the first cost function; and
adjusting parameters of the AE generator model to minimize the first cost function.

4. The computer-readable medium of claim 3 further comprising:

generating, via an AD generator model of the machine learning model, a cyclic AD image using the predicted AE image;
computing a second cost function that is indicative of a difference between the cyclic AD image and the input AD image; and
adjusting parameters of the AD generator model or the AE generator model to minimize the second cost function.

5. The computer-readable medium of claim 4, wherein the training includes training the machine learning model with a different AD image and AE image in each iteration until the AE discriminator model determines whether the predicted AE image is classified as a real image.

6. The computer-readable medium of claim 5, wherein the AE discriminator model determines whether the predicted AE image is classified as a real image when the first cost function or the second cost function is minimized.

7. The computer-readable medium of claim 3, wherein the set of process-related parameters includes parameters associated with one or more processes for forming a pattern on the substrate.

8. The computer-readable medium of claim 2, wherein the iteration includes:

generating, via an AD generator model of the machine learning model, a predicted AD image using a reference AE image of the AE images; and
determining, via an AD discriminator model of the machine learning model, whether the predicted AD image is classified as a real or fake image.

9. The computer-readable medium of claim 8, wherein determining whether the predicted AD image is classified as a real or fake image includes:

computing a third cost function that is indicative of predicted AD images being classified as fake and the AD images being classified as real, wherein the third cost function is further computed based on a set of process-related parameters;
adjusting parameters of the AD discriminator model to maximize the third cost function; and
adjusting parameters of the AD generator model to minimize the third cost function.

10. The computer-readable medium of claim 9 further comprising:

generating, via the AE generator model, a cyclic AE image using the predicted AD image;
computing a fourth cost function that is indicative of a difference between the cyclic AE image and the reference AE image; and
adjusting parameters of the AD generator model or the AE generator model to minimize the fourth cost function.

11. The computer-readable medium of claim 10, wherein the training includes training the machine learning model with a different AD image and AE image in each iteration until the AD discriminator model determines whether the predicted AD image is classified as a real image.

12. The computer-readable medium of claim 11, wherein the AD discriminator model determines whether the predicted AD image is classified as a real image when the third cost function or the fourth cost function is minimized.

13. The computer-readable medium of claim 5, wherein the training includes training the machine learning model until (i) the first cost function, the second cost function, the third cost function, or the fourth cost function is minimized, or (ii) the AE discriminator model determines whether the predicted AE image is classified as a real image and the AD discriminator model determines whether the predicted AD image is classified as a real image.

14. The computer-readable medium of claim 1, wherein the substrate includes a plurality of regions, and wherein the set of unpaired AD and AE images are obtained from a same region of the regions.

15. An apparatus for generating a first image from a second image using a machine learning model, the apparatus comprising:

a memory storing a set of instructions; and
at least one processor configured to execute the set of instructions to cause the apparatus to perform a method of:

obtaining a given after-etch (AE) image associated with a given substrate, wherein the given AE image corresponds to a given location on the given substrate; and
generating, via a machine learning model, a given predicted after-development (AD) image using the given AE image, wherein the given predicted AD image corresponds to the given location, wherein the machine learning model is trained to generate a predicted AD image using a set of unpaired AD images and AE images associated with a substrate.

**FIG. 1**

**FIG. 2**

**FIG. 3**

**FIG. 4A**

**FIG. 4B**

**505**

Paired

$x_i$ $y_i$

506

**510**

Unpaired

$X$ $Y$

526
525

536
535

## FIG. 5

FIG. 6A

EP 4 020 085 A1

**FIG. 6B**

EP 4 020 085 A1

FIG. 7

```
┌─────────────────┐
│       810       │
└─────────────────┘
         │
         │
         │
┌─────────────────┐
│       820       │
└─────────────────┘
```

# FIG. 8

FIG. 9A

FIG. 9B

FIG. 9C

```
┌─────────────────┐
│      1010       │
└─────────────────┘
         │
         │
         │
┌─────────────────┐
│      1020       │
└─────────────────┘
```

# FIG. 10

**FIG. 11**

FIG. 12

FIG. 13

Europäisches Patentamt

European Patent Office

Office européen des brevets

## EUROPEAN SEARCH REPORT

Application Number

EP 20 21 6767

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2020/200993 A1 (ASML NETHERLANDS BV [NL]) 8 October 2020 (2020-10-08) * paragraph [0040] - paragraph [0070]; figures 1-4 * | 1-14 | INV. G03F7/20 G06N3/08 |
| X | WO 2020/078762 A1 (ASML NETHERLANDS BV [NL]) 23 April 2020 (2020-04-23) * paragraph [0056] - paragraph [0072]; figures 1-3 * | 1-14 | |
| A | WO 2020/169303 A1 (ASML NETHERLANDS BV [NL]) 27 August 2020 (2020-08-27) * paragraph [0033] - paragraph [0073]; figures 1-4B * | 1-14 | |
| A | WO 2020/173654 A1 (ASML NETHERLANDS BV [NL]) 3 September 2020 (2020-09-03) * paragraph [0040] - paragraph [0086]; figures 1-4A * | 1-14 | |
| A | WO 2019/162204 A1 (ASML NETHERLANDS BV [NL]) 29 August 2019 (2019-08-29) * paragraph [0057] - paragraph [0125]; figures 1-6 * | 1-14 | TECHNICAL FIELDS SEARCHED (IPC) G03F G06N |

~~The present search report has been drawn up for all claims~~

| Place of search | Date of completion of the search | Examiner |
|---|---|---|
| Munich | 1 June 2021 | Tomezzoli, Giancarlo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-14

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

The Search Division considers that the present European patent application does not comply with the requirements of unity of invention and relates to several inventions or groups of inventions, namely:

```
1. claims: 1-14

    A non-transitory computer-readable medium
                    ---

2. claim: 15

    An apparatus for generating a first image from a second
    image
                    ---
```

**EP 4 020 085 A1**

## ANNEX TO THE EUROPEAN SEARCH REPORT
## ON EUROPEAN PATENT APPLICATION NO.

EP 20 21 6767

This annex lists the patent family members relating to the patent documents cited in the above-mentioned European search report.
The members are as contained in the European Patent Office EDP file on
The European Patent Office is in no way liable for these particulars which are merely given for the purpose of information.

01-06-2021

| Patent document cited in search report | | Publication date | Patent family member(s) | | Publication date |
|---|---|---|---|---|---|
| WO 2020200993 | A1 | 08-10-2020 | NONE | | |
| WO 2020078762 | A1 | 23-04-2020 | CN | 112889005 A | 01-06-2021 |
| | | | KR | 20210057807 A | 21-05-2021 |
| | | | TW | 202028849 A | 01-08-2020 |
| | | | WO | 2020078762 A1 | 23-04-2020 |
| WO 2020169303 | A1 | 27-08-2020 | TW | 202101109 A | 01-01-2021 |
| | | | WO | 2020169303 A1 | 27-08-2020 |
| WO 2020173654 | A1 | 03-09-2020 | TW | 202101110 A | 01-01-2021 |
| | | | WO | 2020173654 A1 | 03-09-2020 |
| WO 2019162204 | A1 | 29-08-2019 | CN | 111886606 A | 03-11-2020 |
| | | | KR | 20200113244 A | 06-10-2020 |
| | | | TW | 201942769 A | 01-11-2019 |
| | | | TW | 202113633 A | 01-04-2021 |
| | | | WO | 2019162204 A1 | 29-08-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 7587704 B